(19) **Europäisches Patentamt / European Patent Office / Office européen des brevets**

(11) **EP 2 507 930 B1**

(12) **FASCICULE DE BREVET EUROPEEN**

(45) Date de publication et mention
de la délivrance du brevet:
**13.03.2019 Bulletin 2019/11**

(51) Int Cl.:
***H04L 1/00*** *(2006.01)*

(21) Numéro de dépôt: **10805456.0**

(86) Numéro de dépôt international:
**PCT/FR2010/052583**

(22) Date de dépôt: **01.12.2010**

(87) Numéro de publication internationale:
**WO 2011/067534 (09.06.2011 Gazette 2011/23)**

(54) **PROCEDE DE TRANSMISSION D'UN SIGNAL NUMERIQUE POUR UN SYSTEME MARC SEMI-ORTHOGONAL AVEC RELAIS HALF-DUPLEX, PRODUIT PROGRAMME ET DISPOSITIF RELAIS CORRESPONDANTS**

VERFAHREN ZUR ÜBERTRAGUNG EINES DIGITALEN SIGNALS FÜR EIN SEMI-ORTHOGONALES FRAME-SYSTEM MIT HALBDUPLEX-RELAIS SOWIE ENTSPRECHENDES PROGRAMMPRODUKT UND RELAIS-VORRICHTUNG

METHOD FOR TRANSMITTING A DIGITAL SIGNAL FOR A SEMI-ORTHOGONAL FRAME SYSTEM HAVING HALF-DUPLEX RELAY, AND CORRESPONDING PROGRAM PRODUCT AND RELAY DEVICE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **02.12.2009 FR 0958573**

(43) Date de publication de la demande:
**10.10.2012 Bulletin 2012/41**

(73) Titulaire: **Orange**
**75015 Paris (FR)**

(72) Inventeurs:
• **HATEFI, Atoosa**
**F-75015 Paris (FR)**
• **VISOZ, Raphaël**
**F-92170 Vanves (FR)**
• **BERTHET, Antoine**
**F-92290 Chatenay Malabry (FR)**

(56) Documents cités:
**US-A1- 2009 221 231    US-A1- 2009 287 979**

• **SANKARANARAYANAN L ET AL: "Hierarchical sensor networks: capacity bounds and cooperative strategies using the multiple-access relay channel model", SENSOR AND AD HOC COMMUNICATIONS AND NETWORKS, 2004. IEEE SECON 2004. 2004 FIRST ANNUAL IEEE COMMUNICATIONS SOCIETY CONFERENCE ON SANTA CLARA, CA, USA, 4 octobre 2004 (2004-10-04), pages 191-199, XP010759593, PISCATAWAY, NJ, USA,IEEE DOI: 10.1109/SAHCN.2004.1381917 ISBN: 978-0-7803-8796-6**
• **GEORG ZEITLER ET AL: "Design of network coding functions in multihop relay networks", TURBO CODES AND RELATED TOPICS, 1 septembre 2008 (2008-09-01), pages 249-254, XP031353696, 2008 5TH INTERNATIONAL SYMPOSIUM ON, IEEE, PISCATAWAY, NJ, USA ISBN: 978-1-4244-2862-5**
• **GEORG ZEITLER ET AL: "An adaptive compress-and-forward scheme for the orthogonal multiple-access relay channel", PERSONAL, INDOOR AND MOBILE RADIO COMMUNICATIONS, 13 septembre 2009 (2009-09-13), pages 1838-1842, XP031659655, IEEE 20TH INTERNATIONAL SYMPOSIUM ON, IEEE, PISCATAWAY, NJ, USA ISBN: 978-1-4244-5122-7**

• HAUSL C ET AL: "Joint network-channel coding for the multiple-access relay channel", 2006 3RD ANNUAL IEEE COMMUNICATIONS SOCIETY ON SENSOR AND ADHOC COMMUNICATIONS AND NETWORKS, SECON 2006 - 2006 3RD ANNUAL IEEE COMMUNICATIONS SOCIETY ON SENSOR AND ADHOC COMMUNICATIONS AND NETWORKS, SECON 2006 2007 INSTITUTE OF ELECTRICAL AND ELECTRO, vol. 3, 25 septembre 2006 (2006-09-25), pages 817-822, XP002592508, DOI: 10.1109/SAHCN.2006.288566 cité dans la demande

**Description**

**Domaine de l'invention**

Le domaine de l'invention est celui de la transmission de données codées dans un réseau MARC. Un réseau MARC est un système de télécommunication à au moins quatre noeuds comprenant au moins deux émetteurs, un relais et un récepteur. Plus précisément, l'invention se rapporte au codage de réseau et elle concerne l'amélioration de la qualité de la transmission des données, et en particulier l'amélioration des performances du décodage correcteur d'erreurs dans un récepteur.

L'invention s'applique notamment, mais non exclusivement, à la transmission de données via des réseaux mobiles, par exemple pour des applications temps réel.

**Art antérieur**

Les réseaux, en particulier mobiles, sont à la recherche de gains significatifs en termes de capacité, de fiabilité, de consommation et autres. Le canal de transmission d'un réseau mobile est réputé difficile et conduit à une fiabilité de transmission relativement médiocre. Des progrès importants ont été réalisés ces dernières années, en matière de codage et de modulation, notamment pour des considérations de consommation et de capacité. En effet, dans un réseau mobile où plusieurs émetteurs/récepteurs partagent les mêmes ressources (temps, fréquence et espace) il faut réduire au maximum la puissance d'émission.

Cette réduction va à l'encontre de la couverture et donc de la capacité du système et plus généralement de ses performances.

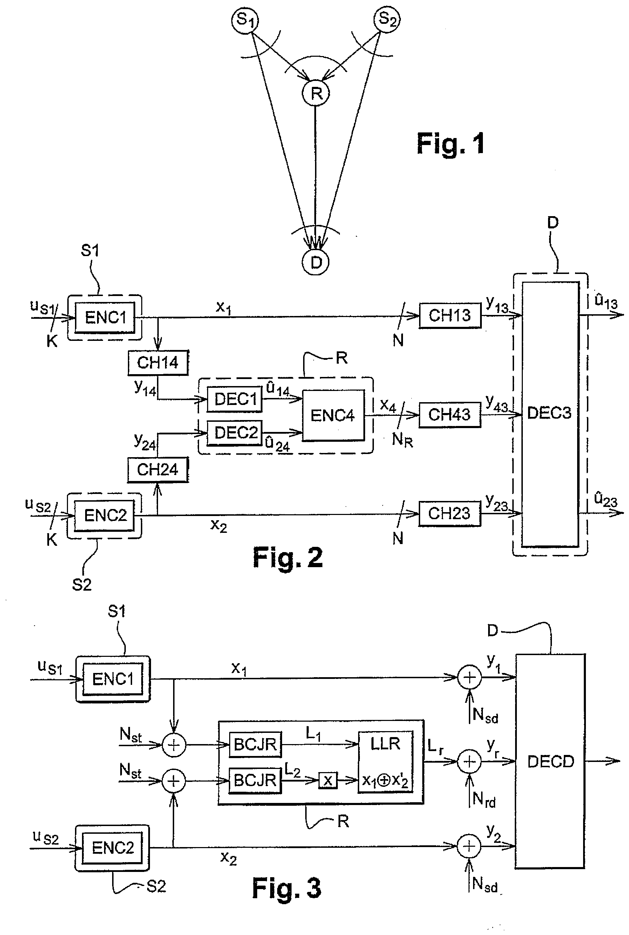

Pour augmenter la couverture, fiabiliser les communications et plus généralement améliorer les performances, une approche consiste à s'appuyer sur des relais pour augmenter l'efficacité spectrale et donc améliorer l'efficacité de transmission et la fiabilité des systèmes. La topologie des systèmes MARC illustrée par la figure 1 est telle que les sources, noeuds $S_1$ et $S_2$, diffusent leurs séquences d'informations codées à l'attention du relais R et du destinataire D. Le relais décode les signaux reçus issus des sources $S_1$ et $S_2$ et ré-encode conjointement ceux-ci en ajoutant une redondance propre créant un code de réseau spatialement distribué. A la destination D, le décodage des trois séquences codées spatialement distribuées, comprenant les deux séquences codées reçues issues directement des sources S1 et S2 et la séquence codée issue du relais, repose sur des algorithmes de décodage conjoint canal/ réseau.

Le codage de réseau est une forme de coopération selon laquelle les noeuds du réseau partagent non seulement leurs ressources propres (puissance, bande, etc.) mais également leur capacité de calcul, pour créer un codage distribué de plus en plus puissant au fur et à mesure que l'information se propage à travers les noeuds. Il amène des gains substantiels en termes de diversité et de codage et donc de fiabilité de transmission.

On distingue deux types de fonctionnement pour le relais : le mode half-duplex et le mode full-duplex.

Selon le mode half-duplex, on distingue deux phases de transmission qui correspondent à des intervalles de transmission différents car le relais est incapable de recevoir et d'émettre simultanément. Pendant la première phase qui comprend les 1$^{er}$ intervalles de transmission (time slots), les deux sources émettent mais pas le relais. Le relais décode/ré-encode conjointement pour déduire le signal à émettre lors des prochains intervalles de transmission. Pendant la deuxième phase qui comprend les 2$^e$ intervalles de transmission, le relais émet le signal déterminé pendant les 1$^{er}$ intervalles de transmission et les sources émettent les deuxièmes séquences de parité relatives aux mêmes informations que celles émises pendant les 1$^{er}$ intervalles de transmission. Les relais de type half-duplex sont attractifs du fait d'un schéma de communication simple et du fait de la facilité de les mettre en oeuvre et de leur coût réduit qui en découlent.

Selon le mode full-duplex, le relais reçoit les nouveaux blocs d'informations de la part des deux sources et transmet simultanément au destinataire son mot de code basé sur les blocs reçus précédemment. Comparativement au relais half-duplex, le relais full-duplex permet d'atteindre une capacité plus grande.

Les articles [1] et [2] décrivent un codage conjoint canal/réseau pour un système MARC, illustré par la figure 2. Le système MARC considéré est tel que tous les liens CH14, CH24, CH13, CH43 et CH23 sont orthogonaux, en outre les liens entre les deux sources et le relais sont supposés parfaitement fiables. Dans la demande le lien est le canal de communication entre deux ou plusieurs noeuds, il peut être physique ou logique. Lorsque le lien est physique alors il est généralement appelé canal. Les deux sources S1, S2 diffusent l'information codée au relais R et au destinataire D pendant la première phase de transmission. Le relais R combine linéairement les flux supposés parfaitement décodés des deux utilisateurs selon un schéma de codage de réseau linéaire. Pendant la seconde phase, le relais émet une séquence de parité supplémentaire au destinataire D. Ce code conjoint canal/réseau peut être considéré, une fois tous les flux reçus, stockés et réorganisés au niveau du destinataire, comme un code conjoint canal/réseau spatialement distribué qui peut être itérativement décodé. Ce code conjoint amène des gains substantiels en termes de diversité et de codage.

S. Yang et R. Koetter [3] ont évalué les performances du codage de réseau pour un système MARC, illustré par la figure 3, avec liens orthogonaux mais en présence de liens sources-relais bruités. Les auteurs proposent la technique "soft decode and forward" qui repose sur la génération d'une distribution de probabilités discrète sur les bits à transmettre obtenue par un algorithme calculant les probabilités à posteriori (APP) sur les bits/symboles codés. Chaque source S1, S2 génère un mot de code transmis au relais R. Le relais R les décode sous la forme d'un rapport logarithmique de probabilités (LLR) en utilisant un algorithme de décodage BCJR, du nom de ses auteurs L.Bahl, J.Cocke, F.Jelinek, and J.Raviv [4], puis effectue un codage de réseau pondéré sans mémoire correspondant à la somme modulo deux bit à bit (opération XOR) des deux mots de code reçus, le codage pondéré consistant à générer à partir des LLR $L_1$, $L_2$ des deux sources un troisième LLR $L_R$ correspondant à l'opération XOR. Ce troisième LLR est finalement transmis de façon analogique vers la destination D. Ainsi, le destinataire dispose de trois observations : celles émanant des deux sources et le LLR. Le destinataire effectue conjointement et d'une manière itérative un décodage des flux de la source $S_1$ et de la source $S_2$ en exploitant l'information supplémentaire fournie par le relais. L'article décrit que, même pour des liens $S_1 \rightarrow R$ et $S_2 \rightarrow R$ sévèrement bruités, le codage de réseau apporte un gain de codage par rapport à un schéma sans coopération, donc sans relais. Le procédé est décrit dans le cas d'une modulation BPSK et ne peut pas être transposé à une modulation avec un ordre supérieure à quatre car l'expression calculée lors de la 3e étape ne peut s'appliquer que pour une modulation d'ordre deux ou quatre (ex.QPSK).

US 2009/287979 A1 (WANG HAIFENG [CN] ET AL) 19 novembre 2009 (2009-11-19)divulgue un système MARC half-duplex à plusieurs sources dans lequel les liens entre les sources et le relais sont orthogonaux.

Dans ces différents systèmes connus, les erreurs de décodage sont réduites uniquement en l'absence d'interférence puisque le système MARC considéré est supposé sans interférence du fait des liens orthogonaux. En outre, la contrainte qui consiste à imposer des liens orthogonaux conduit à une utilisation non optimale de la ressource spectrale donc à une limitation de la capacité du réseau.

**Caractéristiques principales de l'invention**

L'invention a pour objet un procédé de transmission d'un signal numérique destiné à un réseau à au moins quatre noeuds comprenant deux émetteurs, un relais et un récepteur séparés entre eux par des liens non orthogonaux sauf entre le relais et la destination entre lesquels le lien est orthogonal, mettant en oeuvre un code de réseau spatialement distribué, comprenant :

- une étape de codage, dans chaque émetteur, délivrant un mot de code par bloc de K bits d'information.
- une étape d'émission, dans les émetteurs, du mot de code pendant $\alpha N$ intervalles de transmission, $\alpha \in [0,1]$
- une étape de détection/décodage conjoint itératif, dans le relais, pour séparer les flux interférants provenant des émetteurs et déterminer par flux un vecteur représentatif des K bits d'information associés au mot de code,
- une étape de codage conjoint, dans le relais, des deux vecteurs pour déterminer une information de redondance,
- un ordonnancement dans le relais pour émettre l'information de redondance pendant les $(1-\alpha)N$ suivants intervalles de transmission.

L'invention a en outre pour objet un relais destiné à un système MARC semi-orthogonal.

Ainsi, un relais selon l'invention, destiné à la mise en oeuvre d'un procédé de transmission selon l'invention, comprend :

- un moyen de détection/décodage conjoint itératif pour séparer les flux interférants provenant de deux émetteurs du système MARC semi-orthogonal et déterminer, par flux, un vecteur représentatif de K bits d'information associés à un mot de code émis par un émetteur pendant $\alpha N$ intervalles de transmission, $\alpha \in [0,1]$,
- un moyen de codage conjoint des vecteurs des deux flux pour déterminer une information de redondance,
- un moyen pour émettre l'information de redondance pendant $(1-\alpha)N$ intervalles de transmission qui suivent les $\alpha N$ intervalles de transmission pendant lesquels les mots de code sont émis par les deux émetteurs.

L'étape d'émission par les émetteurs intervient de manière simultanée ce qui permet d'utiliser au maximum la ressource spectrale commune. Il y a donc interférence entre les signaux reçus par le relais et il y a interférence entre les signaux reçus par la destination du fait de la superposition des signaux sources lors de la transmission d'une part entre les émetteurs et le relais et d'autre part entre les émetteurs et la destination (le récepteur). En d'autres termes, la transmission depuis les sources est non orthogonale, c'est-à-dire, que les sources utilisent simultanément la même ressource radio, par exemple en temps, en fréquence ou en code.

Ainsi, l'invention repose en particulier sur l'introduction d'une étape de détection/décodage conjoint et d'un codage conjoint dans le relais, ce qui permet de séparer les flux émis simultanément par les deux sources et de faire bénéficier à l'ensemble des émetteurs dispersés du gain de codage d'un code réseau spatialement distribué sans diminuer l'efficacité spectrale. En effet, l'approche de l'invention permet de mettre en oeuvre, dans les récepteurs, un décodage itératif s'appuyant sur une redondance générée dans les relais, reçue par la destination sans interférence en l'absence d'émission simultanée par les émetteurs, sans nécessiter d'augmenter la puissance dans les émetteurs pour atteindre une augmentation de la couverture du système et de l'efficacité spectrale.

Selon un mode de réalisation particulier, un procédé de transmission est tel que l'étape de détection/décodage conjoint itératif met en oeuvre un décodage dur.

Ce mode de décodage avec une décision dure sur la valeur de chacun des bits reçus dans le relais est plus particulièrement adapté à un système MARC semi-orthogonal dans lequel les liens sont parfaitement fiables. Dans ce contexte, le relais peut décoder sans erreur les informations émanant des sources. Un décodage dur est donc particulièrement adapté à un tel système MARC semi-orthogonal car il est de complexité réduite par rapport à un décodage souple et rapide à mettre en oeuvre.

Selon un mode de réalisation particulier, un procédé de transmission est tel que l'étape de détection/décodage conjoint itératif met en oeuvre un décodage souple et l'étape de codage conjoint met en oeuvre un codage souple et une marginalisation effectuée au niveau bit.

Ce mode de décodage est plus particulièrement adapté à un système MARC semi-orthogonal avec des canaux à évanouissements de Rayleigh et avec une méconnaissance aux niveaux des sources des canaux sources/relais. Dans ce contexte, il existe une probabilité non nulle que le relais décode imparfaitement les informations émanant des sources. Le choix d'un décodage souple permet de limiter la propagation d'erreurs par le relais.

Selon un mode de réalisation particulier, un procédé de transmission est tel que l'étape de détection/décodage conjoint itératif met en oeuvre un décodage souple et l'étape de codage conjoint met en oeuvre un codage souple et une compression.

Ce mode de décodage est plus particulièrement adapté à un système MARC semi-orthogonal avec des canaux à évanouissements de Rayleigh et avec une méconnaissance aux niveaux des sources des canaux sources/relais. Dans ce contexte, il existe une probabilité non nulle que le relais décode imparfaitement les informations émanant des sources. Le choix d'un décodage souple permet de limiter la propagation d'erreurs par le relais. En outre, le codage souple suivi d'une compression permet d'utiliser n'importe quelle modulation au relais contrairement au mode avec codage souple et marginalisation qui impose l'utilisation d'une modulation BPSK (ou QPSK) au relais.

Selon un mode de réalisation particulier, un procédé de transmission est tel que la compression est effectuée en utilisant un critère d'erreur quadratique moyenne non corrélée (MMSUE).

L'utilisation du critère MMSUE permet d'effectuer une estimation optimale au relais à partir des probabilités à posteriori et permet donc de maximiser le SNR à la destination en réduisant le nombre d'erreurs dans le relais.

Selon un mode de réalisation particulier, un procédé de transmission met en oeuvre un turbo code distribué entre les émetteurs et le relais. En outre, l'étape de codage dans les émetteurs met en oeuvre un codeur convolutif.

Par exemple, le turbo code distribué est constitué, à un émetteur, d'un code convolutif RSCC de rendement 1/2, et au relais d'un RSCC de rendement 2/3 précédé d'un entrelaceur pour chaque flux issu du décodeur. Le choix d'un turbo code distribué avec concaténation parallèle permet une mise en oeuvre très simple d'un codage de réseau spatialement distribué pour un système MARC semi-orthogonal avec un relais half-duplex en ayant par construction un code composé d'une concaténation d'une partie systématique et de deux parties redondances (une première partie redondance déterminée et émise par émetteur et une seconde partie redondance déterminée et émise par le relais). Cette concaténation permet d'émettre par un des émetteurs pendant le premier intervalle de transmission la partie systématique et la première partie redondance et d'émettre par le relais pendant le second intervalle de transmission la deuxième partie redondance. Cette concaténation permet donc simplement d'obtenir que le relais fournisse une nouvelle information de redondance aux bits d'information correspondant à la partie systématique indépendamment de la première partie redondance transmise pendant le premier intervalle de transmission des émetteurs à la destination. La destination dispose donc de plusieurs redondances ce qui permet un décodage très puissant et donc une amélioration de la fiabilité.

L'invention a en outre pour objet un procédé de réception destiné à un récepteur d'un système MARC semi-orthogonal destiné à mettre en oeuvre un procédé de transmission selon l'invention. Le procédé de réception comprend :

- une étape de mémorisation dans un bloc de données reçues pendant $\alpha N$, intervalles de transmissions, $\alpha \in [0,1]$, correspondant à K bits d'information codés par émetteur sous la forme d'un mot de code émis pendant les $\alpha N$ intervalles de transmission,

et comprenant de manière itérative :

- une étape de détection d'information de redondance provenant d'un relais reçue pendant $(1-\alpha)N$ intervalles de transmission qui suivent les $\alpha N$ intervalles de transmission,
- une étape de détection pour séparer les flux interférants provenant des émetteurs à partir d'un bloc de données reçues,

- une étape de décodage conjoint pour déterminer par émetteur une valeur de décodage des K bits d'information en décodant conjointement les flux séparés et l'information de redondance détectée.

L'invention a en outre pour objet un récepteur destiné à un système MARC semi-orthogonal destiné à mettre en oeuvre un procédé de transmission selon l'invention. Le récepteur comprend :

- un moyen pour mémoriser dans un bloc des données reçues pendant $\alpha N$ intervalles de transmissions, correspondant à K bits d'information codés par émetteur sous la forme d'un mot de code émis pendant les $\alpha N$ intervalles de transmissions, $\alpha \in [0,1]$,
- deux moyens de détection bloc en parallèles suivis d'un décodeur conjoint pour, de manière itérative, séparer les deux flux interférants provenant des émetteurs pendant les $\alpha N$ intervalles de transmission, détecter le flux provenant du relais pendant les $(1-\alpha)N$ intervalles de transmission suivants et déterminer à partir des flux séparés et du flux détecté, une valeur de décodage des K bits d'information par émetteur.

Ce procédé de réception et ce récepteur ont pour avantage d'être adaptés à un système MARC semi-orthogonal mettant en oeuvre un procédé de transmission selon l'invention.

Les différents modes de réalisation précédents peuvent être combinés ou pas avec un ou plusieurs de ces modes pour définir un autre mode de réalisation.

L'invention a en outre pour objet un système MARC semi-orthogonal, éventuellement MIMO, adapté pour la mise en oeuvre d'un procédé selon l'invention.

Ainsi, un système MARC semi-orthogonal selon l'invention, comprend un relais selon l'invention.

Selon une implémentation préférée, les étapes du procédé de transmission, respectivement de réception, sont déterminées par les instructions d'un programme de transmission, respectivement de réception, incorporé dans un ou plusieurs circuits électronique telle des puces elle-même pouvant être disposées dans des dispositifs électroniques du système MARC semi-orthogonal. Le procédé de transmission, respectivement de réception, selon l'invention peut tout aussi bien être mis en oeuvre lorsque ce programme est chargé dans un organe de calcul tel un processeur ou équivalent dont le fonctionnement est alors commandé par l'exécution du programme.

En conséquence, l'invention s'applique également à un programme d'ordinateur, notamment un programme d'ordinateur sur ou dans un support d'informations, adapté à mettre en oeuvre l'invention. Ce programme peut utiliser n'importe quel langage de programmation, et être sous la forme de code source, code objet, ou de code intermédiaire entre code source et code objet tel que dans une forme partiellement compilée, ou dans n'importe quelle autre forme souhaitable pour implémenter un procédé selon l'invention.

Le support d'informations peut être n'importe quelle entité ou dispositif capable de stocker le programme. Par exemple, le support peut comporter un moyen de stockage, tel qu'une ROM, par exemple un CD ROM ou une ROM de circuit microélectronique, ou encore un moyen d'enregistrement magnétique, par exemple une disquette (floppy disc) ou un disque dur.

Alternativement, le support d'informations peut être un circuit intégré dans lequel le programme est incorporé, le circuit étant adapté pour exécuter ou pour être utilisé dans l'exécution du procédé en question.

D'autre part, le programme peut être traduit en une forme transmissible telle qu'un signal électrique ou optique, qui peut être acheminé via un câble électrique ou optique, par radio ou par d'autres moyens. Le programme selon l'invention peut être en particulier téléchargé sur un réseau de type Internet.

**Liste des figures**

D'autres caractéristiques et avantages de l'invention apparaîtront plus clairement à la lecture de la description suivante de modes de réalisation préférentiels, donnés à titre de simples exemples illustratifs et non limitatifs, et des dessins annexés, parmi lesquels :

- la figure 1 est un schéma illustrant la topologie de base des systèmes MARC,
- la figure 2 est un premier exemple d'un système MARC de l'art antérieur avec des liens orthogonaux entre les différents noeuds,
- la figure 3 est un second exemple d'un système MARC de l'art antérieur avec des liens orthogonaux entre les différents noeuds,
- la figure 4 est un exemple d'un système MARC semi-orthogonal selon l'invention avec un lien orthogonal entre le relais et la destination, et des liens non orthogonaux entre les émetteurs et le relais et entre les émetteurs et la destination,
- la figure 5 est un organigramme simplifié du procédé de transmission selon l'invention mis en oeuvre par un système MARC semi-orthogonal illustré par la figure 4,

- la figure 6 est un schéma d'un premier mode de réalisation d'un relais selon l'invention,
- la figure 7 est un schéma d'un deuxième mode de réalisation d'un relais selon l'invention,
- la figure 8 est un schéma d'un troisième mode de réalisation d'un relais selon l'invention,
- la figure 9 est un schéma d'un exemple de compression mise en oeuvre au relais,
- la figure 10 est un schéma détaillé d'un détecteur/décodeur conjoint DET/DEC d'un relais illustré par les figures 6, 7 ou 8,
- la figure 11 est un schéma détaillé d'un MUD d'un détecteur/décodeur conjoint DET/DEC illustré par la figure 10,
- la figure 12 est un schéma détaillé d'un décodeur DECi d'un détecteur/décodeur conjoint DET/DEC illustré par la figure 10,
- la figure 13 est un schéma d'un détecteur/décodeur conjoint d'un récepteur selon l'invention,
- la figure 14 est un schéma de séquençage des opérations au relais selon l'invention,
- la figure 15 est un schéma détaillé d'un détecteur/décodeur conjoint d'un récepteur selon l'invention.

## Description de modes de réalisation particuliers

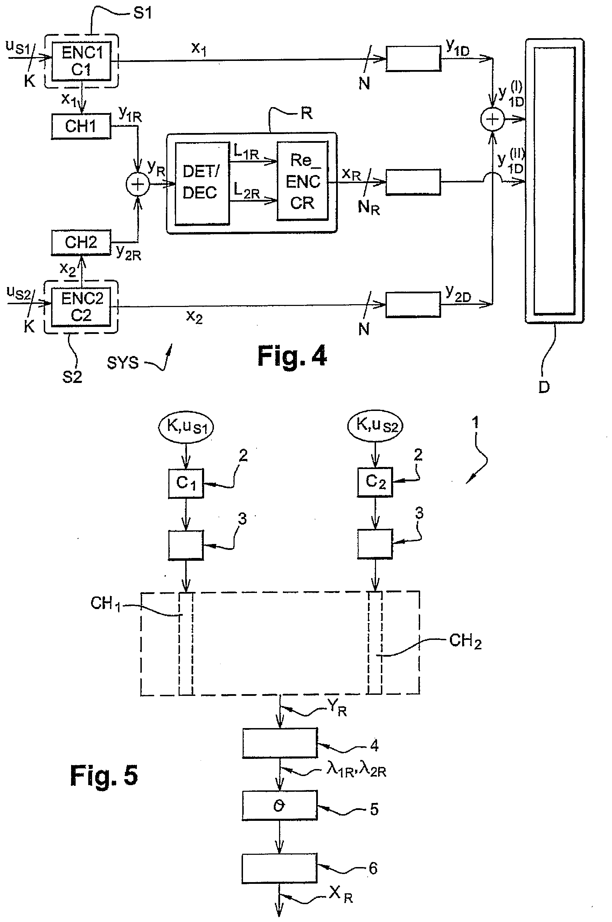

L'invention propose une nouvelle approche de l'utilisation d'un relais d'un système MARC semi-orthogonal illustré par la figure 4, pour améliorer l'efficacité spectrale de la transmission selon un procédé 1 selon l'invention illustré par la figure 5, tout en permettant un décodage simple et efficace dans le récepteur.

Il n'y a aucune contrainte sur le canal de transmission ; il peut être à évanouissement rapide (fast fading) ou lent (slow fading), il peut être sélectif en fréquence, et il peut être MIMO. Dans la suite de la description, les deux sources, le relais, et la destination sont supposées parfaitement synchronisés et les deux sources sont indépendantes (il n'y a pas de corrélation entre elles).

Les notations suivantes sont utilisées dans la demande.

Tous les vecteurs utilisent des caractères **gras.**

Un vecteur **v** a son $k^{\text{ième}}$ élément noté $[\mathbf{v}]_k$ ou $v_k$.
Une fonction multidimensionnelle F porte en entrée sur une matrice **A** de dimension $m \times q$ où chaque élément $a_{i,j}$ (pour tout i=1, ..,m et j=1,..,q) appartient à l'ensemble E et détermine une matrice **B** de dimension $n \times p$ dont chaque élément $b_{i,j}$ (pour tout i=1, ..., n et j=1, ...,p) appartient à l'ensemble G, telle que F(**A**) = **B** dénotée :

$$F : E^{m \times q} \to G^{n \times p}$$

La densité de probabilité d'une variable aléatoire complexe **x** qui suit une distribution gaussienne à symétrie circulaire de moyenne $\mu_x$ et de covariance $\sigma_x^2$ est notée : $CN(\mu_x, \sigma_x^2)$.

$F_2$ est le corps de Galois à deux éléments, R le corps des réels et C le corps des complexes. Soit **X** une matrice de dimension $N \times M$ appartenant au corps E, c'est-à-dire $\mathbf{X} \in E^{N \times M}$, $\mathbf{x}_k$ dénote sa $k^{\text{ième}}$ colonne (k=1,...,M).

Les fonctions utilisent des caractères majuscules non-italiques.

Soit x une variable aléatoire discrète avec la loi de probabilité $p(x)$, E(**x**) désigne l'espérance mathématique de x:

$$\mathrm{E}(\mathrm{x}) = \sum_i x_i p(x_i)$$

Les deux sources S1, S2 (les deux émetteurs) statistiquement indépendantes et équipées respectivement de $T_{S_1}$ et $T_{S_2}$ antennes, effectuent un codage 2 des données d'information $\mathbf{u}_{S_1}$, $\mathbf{u}_{S_2}$ segmentées par bloc de K bits en appliquant des schémas de modulation et de codage canal espace temps $C_1$, et $C_2$ mis en oeuvre par des codeurs ENC1 et ENC2. Le schéma de modulation et de codage $C_1$, respectivement $C_2$, d'une source permet donc d'associer 2 à tout vecteur d'information $\mathbf{u}_{S_1} \in F_2^K$, respectivement $\mathbf{u}_{S_2} \in F_2^K$, des symboles codés et modulés $\mathbf{X}_{S_1} \in \chi_1^{T_{S_1} \times N_s}$, respectivement $\mathbf{X}_{S_2} \in \chi_2^{T_{S_2} \times N_s}$ appartenant aux constellations complexes $\chi_1$ et $\chi_2$ de cardinalités $|\chi_1|$ = $2^p$ et $|\chi_2| = 2^q$ $(p, q \in \mathbb{N})$ :

$$C_1 : F_2^K \rightarrow \chi_1^{T_{S_1} \times N_s}$$

$$C_2 : F_2^K \rightarrow \chi_2^{T_{S_2} \times N_s}$$

$\mathbf{X}_{S_1}$ et $\mathbf{X}_{S_2}$ sont dénommés par la suite mots de code finaux émis respectivement par les sources $S_1$ et $S_2,$.

Les sources émettent 3 ensuite, pendant une première phase, les mots de code finaux $\mathbf{X}_{S_1} \in \chi_1^{T_{S_1} \times N_s}$ et $\mathbf{X}_{S_2} \in \chi_2^{T_{S_2} \times N_s}$ durant $N_s = \alpha N$ utilisations de canal ($\alpha N$ intervalles de transmission) avec $\alpha \in [0,1]$.

Le relais R équipé de $R_x$ antennes de réception et $T_R$ antennes d'émission reçoit pendant la première phase, les données $\mathbf{Y}_R \in C^{R_x \times N_s}$ qui sont une superposition des mots de code $\mathbf{Y}_{1R} \in C^{R_x \times N_s}$, $\mathbf{Y}_{2R} \in C^{R_x \times N_s}$ (ou au moins de certains d'entre eux) transmis par le canal CH1, CH2.

Dans la suite du document, les termes génériques "mots de code" sont utilisés en relation avec $\mathbf{X}_{S_1}$ et $\mathbf{X}_{S_2}$ et plus généralement pour tous vecteurs/matrices obtenus à l'issu d'un codage avec un schéma de modulation et de codage Ci.

Les mots de code $\mathbf{Y}_{1R}$, $\mathbf{Y}_{2R}$ sont donc une version perturbée des mots de code émis $\mathbf{X}_{S_1}$, $\mathbf{X}_{S_2}$ et leur superposition peut s'exprimer sous la forme :

$$\mathbf{y}_{R,k} = \mathbf{y}_{1R,k} + \mathbf{y}_{2R,k}$$
$$= \sum_{m=0}^{M} \mathbf{H}_{S_1R,k,m} \mathbf{x}_{S_1,k-m} + \sum_{m=0}^{M} \mathbf{H}_{S_2R,k,m} \mathbf{x}_{S_2,k-m} + \mathbf{n}_{SR,k} \qquad (1)$$

$$k = 1,...,\alpha N \; , \; \alpha \in [0,1]$$

Où $\mathbf{n}_{SR,k} \in C^{R_x}$ désigne le vecteur de bruit additif, $\mathbf{H}_{S_1R} \in C^{R_x \times T_{S_1}}$ et $\mathbf{H}_{S_2R} \in C^{R_x \times T_{S_2}}$ désignent les matrices de coefficients d'évanouissement (fading) entre les deux sources et le relais, et M désigne la mémoire du canal (l'effet mémoire du canal est lié au retard de propagation ou delay spread). Ce retard entraîne une superposition des signaux transmis ce qui se traduit par de l'interférence entre les symboles.

Le relais R fait une détection/décodage conjointe 4 des données reçues de façon « dure » ou de façon « souple » au moyen d'un détecteur/décodeur conjoint DET/DEC pour en déduire les vecteurs de valeurs réelles $\lambda_{1R} \in R^K$, $\lambda_{2R} \in R^K$ représentatifs des données binaires des deux sources.

Le relais applique 5 ensuite à partir de ces deux vecteurs $\lambda_{1R}$ et $\lambda_{2R}$ une fonction $\Theta$, détaillée par la suite, pour obtenir l'information de redondance $\mathbf{X}_R = \Theta(\lambda_{1R}, \lambda_{2R}) \in C^{T_R \times N_R}$ qui est envoyée 6 à la destination par le relais sur $N_R = (1-\alpha)N$ utilisations du canal et pendant la deuxième phase de transmission (N désigne le nombre total des utilisations du canal pendant les deux phases de transmission).

Pendant cette deuxième phase, les sources n'émettent pas.

Le destinataire observe une superposition des symboles émis par les sources pendant la première phase de transmission et des symboles émis par le relais pendant la deuxième phase. Le destinataire effectue une détection/décodage conjointe itérative pour récupérer les messages $\mathbf{u}_{S_1}$ et $\mathbf{u}_{S_2}$ à partir de ces signaux.

Selon différents modes de réalisation, la topologie de base peut être répétée pour déterminer un système MARC semi-orthogonal à plusieurs relais et plusieurs destinations, chaque relais étant associé à au moins deux émetteurs et un récepteur. Selon d'autres modes de réalisation, les deux émetteurs d'une topologie de base peuvent ne faire qu'un avec au moins deux antennes d'émission. Dans tous les cas, le relais et le récepteur reçoivent des mots de code transmis via des canaux de transmission distincts.

Chaque relais R fournit donc des mots de code de redondance $\mathbf{X}_R$ qui permettent d'améliorer le décodage au récepteur. Ces mots de code de redondance sont formés en séparant les flux provenant des deux émetteurs puisque les mots de code $\mathbf{Y}_{1R}$, $\mathbf{Y}_{2R}$ provenant des deux émetteurs $S_1$, $S_2$ sont superposés dans un même flux reçu $\mathbf{Y}_R$ du fait des liens S1->R, S2->R non orthogonaux, et en codant conjointement les valeurs extraites des flux superposés.

De nombreuses variantes de mises en oeuvre peuvent être envisagées, en fonction du type de codage, de la concaténation des codes (parallèle, série, ou quelconque).

De nombreux types de codes peuvent être utilisés dans les émetteurs et dans les relais, dès lors qu'il s'agit de codes linéaires. Il peut notamment s'agir de :

- codes convolutifs ;
- codes BCH ;
- codes RS ;
- turbo-codes ;
- codes LDPC binaires ou non-binaires ;
- codes de parité.

Il est possible d'utiliser le même code dans les émetteurs et les relais, ou des codes différents.

Selon un premier mode de réalisation, le système MARC illustré par la figure 4 comporte des liens CH1, CH2 entre les sources S1, S2 et le relais R qui sont supposés parfaitement fiables, autrement dit les liens sont de très bonne qualité et le décodage est quasiment sans erreur.

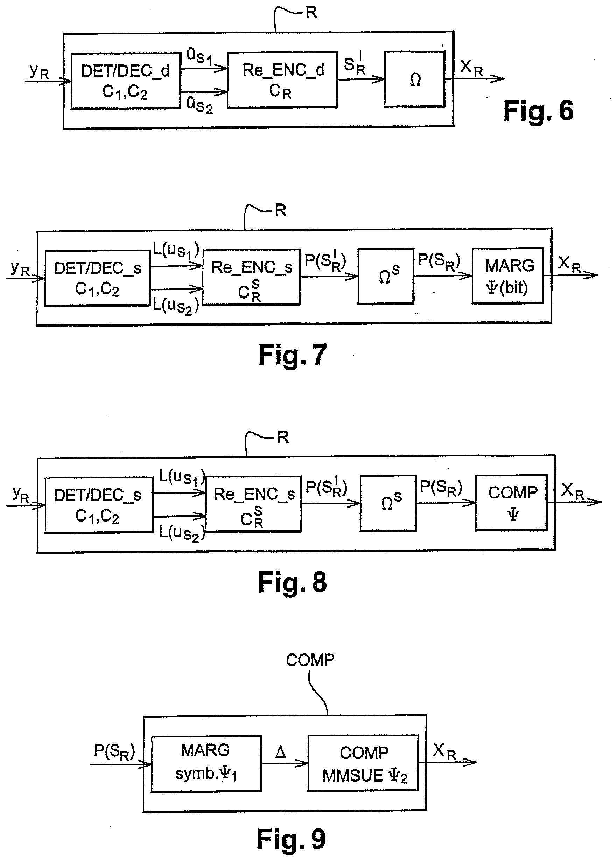

Le relais R, illustré par la figure 6, décode de façon dure les données des deux sources à l'aide d'un détecteur/décodeur conjoint dur DET/DEC_d et il les ré-encode conjointement à l'aide d'un codeur conjoint dur Re_ENC_d à partir du schéma de modulation et de codage espace temps $C_R$.

Les sorties $\hat{\mathbf{u}}_{S_1}$, $\hat{\mathbf{u}}_{S_2}$ du détecteur/décodeur conjoint DET/DEC_d prennent des valeurs binaires exploitées par le codeur conjoint Re_ENC_d :

$$\lambda_{1R} = \hat{\mathbf{u}}_{S_1} \in F_2^K$$

$$\lambda_{2R} = \hat{\mathbf{u}}_{S_2} \in F_2^K$$

Le codeur conjoint dur Re_ENC_d exploite en entrée deux vecteurs de valeurs binaires et produit une matrice de symboles discrets $\mathbf{S}_R^1 \in \chi_R^{T_R \times N_1}$ où $\chi_R$ est une constellation complexe de cardinalité $|\chi_R| = 2^m$ $(m \in \mathbb{N})$ en appliquant le schéma de modulation et de codage espace temps $C_R$ : $C_R : F_2^K \times F_2^K \rightarrow \chi_R^{T_R \times N_1}$ $C_R$ qui produit les symboles discrets $\mathbf{S}_R^1 \in \chi_R^{T_R \times N_1}$. Ensuite, une fonction de sélection de colonnes $\Omega$ est appliquée : $\Omega : \chi_R^{T_R \times N_1} \rightarrow \chi_R^{T_R \times N_0}$, $N_0 \leq N_1$ qui choisit $N_0$ colonnes de la matrice $\mathbf{S}_R^1 \in \chi_R^{T_R \times N_1}$ pour obtenir les symboles de redondances $\mathbf{S}_R \in \chi_R^{T_R \times N_0}$ telle que $\mathbf{S}_R = \Omega(\mathbf{S}_R^1)$

Le relais émet ces symboles discrets $\mathbf{X}_R$ pendant $N_0 = N_R$ intervalles de transmission. Ces symboles discrets $\mathbf{X}_R$ peuvent être exprimés sous la forme :

$$\mathbf{X}_R = \beta \mathbf{S}_R = \Theta(\hat{\mathbf{u}}_{S_1}, \hat{\mathbf{u}}_{S_2}) \in \chi_R^{T_R \times N_R}$$

où $\beta$ est un facteur de normalisation en puissance et $\Theta$ est une fonction déterministe des données estimées des deux sources.

Selon un deuxième mode de réalisation, le système MARC semi-orthogonal illustré par la figure 4 comporte des liens CH1, CH2 entre les sources S1, S2 et le relais R avec un évanouissement de Rayleigh. En outre, les sources n'ont pas de connaissance du lien séparant une source du relais. Il existe par conséquent une probabilité non nulle que le relais décode imparfaitement les messages des deux sources. Dans ces conditions, il y a un risque que le relais propage des erreurs vers le destinataire.

Ce mode permet la prise en compte au niveau du destinataire lors du décodage conjoint, des erreurs de décodage intervenues au relais.

Selon ce mode, le relais R illustré par les figures 7 et 8, effectue une détection/décodage conjointe souple au moyen d'un détecteur/décodeur conjoint souple DET/DEC_s pour obtenir les probabilités a posteriori (APP) des bits d'information, ($\{P(u_k = 0,1)\}$).

Les APP des bits d'information sont calculées sous forme de rapport de vraisemblance (LLR Log-Likelihood-Ratio) définis comme :

$$\left[\lambda_{1R}\right]_k = L(u_{S_i,k}) = \left[\mathbf{L}(\mathbf{u}_{S_i})\right]_k = \ln\frac{P(u_{S_i,k}=1)}{P(u_{S_i,k}=0)} \quad k=1,\cdots,K \quad i=1,2 \ .$$

Ainsi :

$$\lambda_{1R} = \mathbf{L}(\mathbf{u}_{S_1}) \in R^K$$

$$\lambda_{2R} = \mathbf{L}(\mathbf{u}_{S_2}) \in R^K$$

Le relais effectue ensuite un ré-encodage conjoint espace temps de réseau pondéré, à l'aide d'un codeur conjoint Re_ENC_s, détaillé par la suite, à partir du schéma de modulation et de codage $C_R$ :

$$C_R : F_2^K \times F_2^K \rightarrow \chi_R^{T_R \times N_1}$$

Le codeur exploite deux vecteurs de valeurs binaires et produit une matrice de symboles discrets $\mathbf{S}_R^1$ appartenant à $\chi_R^{T_R \times N_1}$ où $\chi_R$ est une constellation complexe de cardinalité $|\chi_R| = 2^m$ $(m \in \mathbb{N})$.

La fonction d'encodage espace temps de réseau pondéré qui utilise un algorithme BCJR appliqué au code $C_R$ est représentée sous la forme :

$$C_R^S : R^K \times R^K \rightarrow R^{(|\chi_R|^{T_R}-1)\times N_1}$$

La fonction d'encodage de réseau pondéré, mise en oeuvre par le codeur conjoint Re_ENC_s, exploite deux vecteurs de valeurs réelles (les vecteurs de LLRs des bits décodés), et fournit les probabilités des symboles ($T_R$ dimensionnels) $\mathbf{s}_{R,k}^1 \in \chi_R^{T_R}$ sous la forme de ($2^{mT_R}$-1) LLR :

$$\ln\frac{P(\mathbf{s}_{R,k}^1=\mathbf{a}_i)}{P(\mathbf{s}_{R,k}^1=\mathbf{a}_0)}$$

Soit :

$$\mathbf{P}(\mathbf{S}_R^1)_{i,k} = \ln\frac{P(\mathbf{s}_{R,k}^1=\mathbf{a}_i)}{P(\mathbf{s}_{R,k}^1=\mathbf{a}_0)}$$

avec $\mathbf{a}_i \in \chi_R^{T_R}$ et $\bigcup\limits_{i=0}^{2^{mT_R}-1} \{\mathbf{a}_i\} = \chi_R^{T_R}$, $i=1,...,2^{mT_R}$-1, $k=1,...,N_1$. ce qui détermine la matrice $\mathbf{P}(\mathbf{S}_R^1) \in R^{(|\chi_R|^{T_R}-1)\times N_1}$ .

A la fin, une fonction de sélection de colonnes $\Omega^S$ (qui supprime toutes les probabilités relatives aux vecteurs supprimés par la fonction de sélection de colonnes $\Omega$) est appliquée à la matrice $\mathbf{P}(\mathbf{S}_R^1) \in R^{(|\chi_R|^{T_R}-1)\times N_1}$ . Ainsi, on définit

la fonction

$$\Omega^S : R^{(|\chi_R|^{T_R}-1) \times N_1} \rightarrow R^{(|\chi_R|^{T_R}-1) \times N_0} \ , \quad N_0 \le N_1 \text{ telle que } \mathbf{P}(\mathbf{S}_R) = \Omega^S \left( \mathbf{P}(\mathbf{S}_R^1) \right)$$

Cette fonction de sélection de colonnes permet de choisir la taille de redondance à envoyer au récepteur. Ceci a pour avantage d'introduire de la flexibilité dans le procédé et, en particulier, d'adapter la taille de redondance en fonction du code utilisé à l'émission.

Le relais illustré par la figure 7 correspond à un mode particulier selon lequel le ré-encodage conjoint est suivie d'une marginalisation MARG avant émission du vecteur de redondance.

Ce mode particulier est adapté pour un relais dans lequel le schéma de modulation et de codage espace temps $C_R$ est basé sur une fonction de codage binaire (pouvant comprendre un entrelaceur) : $C : F_2^K \times F_2^K \rightarrow F_2^{N_1 \times T_R \times m}$ et sur une modulation (une fonction de codage bit à symbole) associant des bits à des symboles $\varphi_R : F_2^m \rightarrow \chi_R \subseteq \mathbb{C}$ ($\subseteq$ signifie "sous ensemble de"), où $\chi_R$ désigne la constellation des symboles obtenus de cardinalité $|\chi_R| = 2^m$, c'est-à-dire que

$$s_{R,k,t}^1 = \varphi_R(c_{R,k,t(1)}^1, \cdots, c_{R,k,t(m)}^1) \ .$$

Un exemple de ce schéma de codage et modulation espace temps est la ST-BICM.

L'opération de marginalisation $\Psi$ consiste à calculer les probabilités au niveau des bits à partir des probabilités des symboles $P(\mathbf{s}_{R,k})$ mémorisées sous forme de $\mathbf{P}(\mathbf{S}_R)_{i,k}$, pour fournir des logarithmes d'un rapport d'APP.

En supposant que $\mathbf{C}_R \in F_2^{N_0 \times T_R \times m}$ soit l'information de redondance binaire et que

$$c_{R,k,t(l)} = \varphi_{R(l)}^{-1}(s_{R,k,t})$$

désigne le $l$ème bit du symbole $s_{R,k,1}$ ($k=1,...,N_0$, $l=1,...,m$, $t=1,\cdots,T_R$), l'application de la fonction de marginalisation $\Psi$ décrite par l'expression : $\Psi : R^{(|\chi_R|^{T_R}-1) \times N_0} \rightarrow R^{T_R \times m \times N_0}$ permet d'obtenir les LLR $L(c_{R,k,t(l)})$ des bits $c_{R,k,t(l)}$ :

$$L(c_{R,k,t(l)}) = \ln \left( \frac{P(c_{R,k,t(l)} = 1)}{P(c_{R,k,t(l)} = 0)} \right)$$

à partir des probabilités :

$$P(c_{R,k,t(l)} = b) = \sum_{a \in \chi_R^{T_R} : \varphi_l^{-1}(a_l) = b} P(\mathbf{s}_{R,k} = \mathbf{a}) \qquad b = 0,1$$

Où:

$$P(\mathbf{s}_{R,k} = \mathbf{a}_i) = c_0 e^{\mathbf{P}(\mathbf{S}_R)_{i,k}} \quad i = 1, \cdots, 2^{mT_R} - 1 \text{ avec } c_0 = P(\mathbf{s}_{R,k} = \mathbf{a}_0) = \frac{1}{1 + \sum\limits_{i=1}^{2^{mT_R}-1} e^{\mathbf{P}(\mathbf{S}_R)_{i,k}}}$$

Soit la matrice $\mathbf{L}(c_R) \in R^{T_R \times mN_0}$ définie comme suit

$$\left[\mathbf{L}(\mathbf{c}_R)\right]_{t,(k-1)m+l} = L(c_{R,k,t(l)}) \quad k=1,\cdots,N_0, t=1,\cdots,T_R, l=1,\cdots,m$$

,

alors l'information de redondance $\mathbf{X}_R = \beta \mathbf{L}(\mathbf{c}_R)$ est émise à destination du récepteur pendant $N_R = mN_0$ intervalles de transmission ($N_R = mN_0/2$ si le procédé utilise la voie en quadrature et en phase) où $\beta$ est un facteur de normalisation en puissance.

Ce mode particulier est applicable à toutes les modulations, mais comme le relais transmet les valeurs souples correspondant aux bits, sous forme de LLR, l'efficacité spectrale est limitée à celle disponible pour la modulation BPSK(ou QPSK).

Le relais illustré par la figure 8 correspond à un mode particulier selon lequel le ré-encodage conjoint est suivie d'une compression COMP avant émission du vecteur de redondance. La fonction de compression $\Psi$ peut s'exprimer sous la forme :

$$\Psi : R^{(|\chi_R|^{T_R}-1)\times N_0} \rightarrow C^{T_R \times N_0}$$

L'opération de compression de la distribution des probabilités a pour avantage de permettre la transmission de toutes les informations souples concernant les probabilités d'un symbole fournies par l'encodeur sur un seul intervalle de transmission, quelle que soit la modulation du schéma de modulation et de codage $C_R$.

L'exemple suivant correspond au cas particulier d'une compression MMSUE. Le schéma des opérations au relais pour mettre en oeuvre la compression MMSUE est illustré par la figure 9.

La fonction $\Psi_1$ de marginalisation au niveau des symboles représentée par :

$$\Psi_1 : R^{(|\chi_R|^{T_R}-1)\times N_0} \rightarrow R^{T_R \times (|\chi_R|-1)\times N_0}$$

exploite les vecteurs des LLRs $\mathbf{P}(\mathbf{S}_R) \in R^{(|\chi_R|^{T_R}-1)\times N_0}$ et fournit les LLRs $\Delta_{t,j,k}$. Soient :

$$\Delta \in R^{T_R \times (|\chi_R|-1)\times N_0}$$

avec :

$$\Delta_{t,j,k} = \ln \frac{P(s_{R,k,t}=b_j)}{P(s_{R,k,t}=b_0)}$$

et

$$b_j \in \chi_R, \bigcup_{i=0}^{2^m-1}\{b_j\} = \chi_R \quad , \quad j=1,\ldots,2^m-1, k=1,\ldots N_0, t=1,\ldots,T_R$$

Où:

$$P(s_{R,k,t}=b_j) = \sum_{i:a_{i,t}=b_j} P(\mathbf{s}_{R,k}=\mathbf{a}_i) = \sum_{i:a_{i,t}=b_j} c_0 e^{\mathbf{P}(\mathbf{S}_R)_{i,k}}$$

$$b_j \in \chi_R, j=0,\ldots,2^m-1 \quad , \quad i=1,\cdots,2^{mT_R}-1 \quad , \quad c_0 = P(\mathbf{s}_{R,k}=\mathbf{a}_0) = \frac{1}{1+\sum_{i=1}^{2^{mT_R}-1} e^{\mathbf{P}(\mathbf{S}_R)_{i,k}}}$$

Cette fonction de marginalisation peut être directement intégrée dans l'étape de ré- encodage/modulation souple selon une réalisation particulière.

La fonction $\Psi_2$ de compression MMSUE consiste à calculer l'espérance des symboles $s_{R,k,t}$. Elle est représentée sous la forme :

$$\Psi_2 : R^{T_R \times (|\chi_R|-1) \times N_0} \rightarrow C^{T_R \times N_0}.$$

Elle exploite les LLRs $\Delta_{t,j,k}$ et calcule :

$$\mathrm{E}(s_{R,k,t}) = \sum_{j=0}^{|\chi_R|-1} b_j P(s_{R,k,t} = b_j) = \sum_{j=0}^{|\chi_R|-1} b_j K_0 e^{\Delta_{t,j,k}}$$

$$b_j \in \chi_R, j = 0,\ldots,2^m - 1 \quad , \quad \text{avec} \quad K_0 = P(s_{R,k,t} = b_0) = \frac{1}{1 + \sum_{j=1}^{|\chi_R|-1} e^{\Delta_{t,j,k}}} \quad , \quad \Delta_{t,0,k} = 0$$

Les espérances $\mathrm{E}(s_{R,k,t})$ calculées sont stockées dans une matrice $\mathrm{E}(\mathbf{s}_R) \in C^{T_R \times N_0}$ et l'information de redondance $\mathbf{X}_R = \beta \mathbf{E}(\mathbf{s}_R)$ est envoyée à la destination pendant $N_R = N_0$ utilisations du canal où $\beta$ est un facteur de normalisation en puissance.

Dans la suite de la description d'un exemple particulier de mise en oeuvre d'un relais, les sources S1, S2 (les émetteurs) sont supposées mettre en oeuvre des schémas de modulation et codage BICM (Bit Interleaved Coded Modulation), c'est-à-dire que ces schémas comprennent une concaténation série d'un encodeur binaire, d'un entrelaceur bit-à-bit (dénommé entrelaceur du canal) et d'un modulateur. Les émetteurs considérés comprennent donc des entrelaceurs pseudo-aléatoires au niveau du bit, avant la transmission des signaux. Par conséquent, aussi bien le relais que le récepteur comprennent les désentrelaceurs correspondants. Les entrelaceurs sont utilisés pour casser la corrélation entre les bits consécutifs transmis ce qui permet d'effectuer plus efficacement une détection/décodage conjointe itérative.

Pour simplifier les notations, on suppose par la suite qu'une seule antenne d'émission et une seule antenne de réception sont utilisées dans tous les émetteurs et récepteurs, donc, $T_{S_1} = T_{S_2} = R_x = 1$. En outre, il est supposé que les évanouissements de Rayleigh sont quasi statiques, que le canal est sans mémoire et que les récepteurs disposent d'une connaissance parfaite de la variance du bruit et des coefficients d'évanouissement (fading).

Les schémas de codage correspondant aux deux sources associent à tout vecteur message $\mathbf{u}_{S_1} \in F_2^K$ et $\mathbf{u}_{S_2}$

$\in F_2^K$ des bits codés $\mathbf{c}_{S_1} \in F_2^{n_1}$ et $\mathbf{c}_{S_2} \in F_2^{n_2}$ ($n_1$ et $n_2$ : longueurs des bits codés) qui sont entrelacés pour donner

$\mathbf{V}_{S_1} \in F_2^{N_s \times p}$ et $\mathbf{V}_{S_2} \in F_2^{N_s \times q}$, puis modulés (à partir des schémas de modulations des deux sources) aux symboles

(mots de code) $\mathbf{x}_{S_1} \in \chi_1^{N_s}$ et $\mathbf{x}_{S_2} \in \chi_2^{N_s}$ qui appartiennent à une constellation complexe. En supposant que les

étiquetages utilisés soient $\varphi_1 : F_2^p \rightarrow \chi_1 \subseteq C$ et $\varphi_2 : F_2^q \rightarrow \chi_2 \subseteq C$, où chaque symbole modulé de $S_1$ et $S_2$ appartient respectivement aux ensembles complexes $\chi_1$ et $\chi_2$ de cardinalités $|\chi_1|=2^p$ et $|\chi_2|=2^q$ alors

$v_{S_i,k(l)} = \varphi_{i(l)}^{-1}(x_{S_i,k})$ désigne le $l^{ème}$ bit de l'étiquetage binaire de $x_{S_i,k}$ ($k=1,\ldots,N_s$, $l=1,\ldots,p$ pour $S_1$, et $l=1,\ldots,q$ pour $S_2$).

Le schéma de codage et modulation correspondant au relais, $C_R$, est basé sur un code binaire

$F_2^K \times F_2^K \rightarrow F_2^n$ (le vecteur des bits codés (des redondances) est noté $c_R$, $c_R \in F_2^{n'}$, $n' < n$), un entrelaceur (les bits codés et entrelacés sont désignés par $\mathbf{V}_R \in F_2^{N_R \times m}$) et un modulateur avec un codage bit à symbole

$$\varphi_{\mathrm{R}} : F_2^m \rightarrow \chi_R \subseteq C$$ , où $\chi_R$ désigne la constellation des symboles obtenus de cardinalité $|\chi_R|=2^m$. Le signal (mot de code) émis par le relais est désigné par $\mathbf{x}_R \in C^{N_R}$.

Le fonctionnement du relais est décrit ci-après plus en détail.

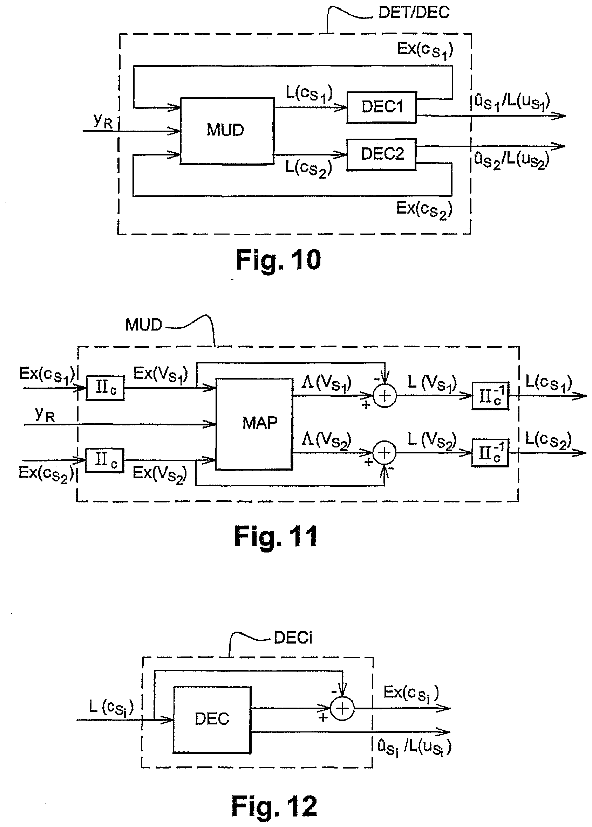

Le détecteur/décodeur conjoint DET/DEC est illustré par la figure 10. La description couvre aussi bien le cas où ce détecteur/décodeur prend une décision dure qu'une décision souple.

Le détecteur/décodeur conjoint DET/DEC applique un schéma de détection/décodage conjoint de manière itérative. Ce schéma est mis en oeuvre par un détecteur multi utilisateurs MUD suivi de deux décodeurs DEC1 et DEC2 en parallèle.

Le relais R reçoit une superposition des signaux des deux sources S1, S2 exprimée par la relation (1) qui se simplifie dans le cas où le canal n'introduit pas de retard de propagation (canal quasi statique sans mémoire) :

$$\begin{aligned} y_{R,k} &= y_{1R,k} + y_{2R,k} \\ &= h_{S_1R} x_{S_1,k} + h_{S_2R} x_{S_2,k} + n_{SR,k} \end{aligned} \qquad k = 1,\dots,\alpha N \quad (2)$$

Où $n_{SR,k}$ désigne le bruit additif gaussien qui a pour distribution $CN(0,\sigma_n^2)$ et où $h_{S_1R}$ et $h_{S_2R}$ désignent les coefficients du lien entre une source S1, S2 et le relais R.

A chaque itération, le détecteur multi utilisateur MUD, schématisé à la figure 11, sépare les flux à partir des données reçues $\mathbf{y}_R$, extrait les informations issues de chacune des sources en mettant en oeuvre un détecteur MAP (Maximum a posteriori). Le détecteur MAP calcule les informations souples des bits codés des deux sources, sous la forme d'un rapport logarithmique de probabilité (LLR) $\{\mathbf{L}(\mathbf{c}_{S_1})\}$ et $\{\mathbf{L}(\mathbf{c}_{S_2})\}$, en exploitant l'observation bruitée issue du canal $\mathbf{y}_R$ et les informations à priori sur des bits codés et entrelacés $\{\mathbf{E}_x(\mathbf{V}_{S_1})\}$ et $\{\mathbf{E}_x(\mathbf{V}_{S_2})\}$ fournies par le décodeur DECi à l'itération précédente.

Le rapport logarithmique de probabilité (LLR) d'un $l^{\text{ème}}$ bit d'un symbole de chaque source $v_{S_i(l)} = \varphi_{i(l)}^{-1}(x_{S_i})$ est calculé selon les équations suivantes :

(Pour simplifier les notations, les indices de temps sont omis.)

$$\begin{aligned} \Lambda(v_{S_i(l)}) &= \log \frac{P(v_{S_i(l)}=1 \mid y_R)}{P(v_{S_i(l)}=0 \mid y_R)} \\ &= \log \frac{\sum_{x_i \in \chi_i : \varphi_{i(l)}^{-1}(x_i)=1} \sum_{x_j \in \chi_j} p(y_R \mid x_{S_i}=x_i, x_{S_j}=x_j) e^{\xi(x_i)+\xi(x_j)}}{\sum_{x_i \in \chi_i : \varphi_{i(l)}^{-1}(x_i)=0} \sum_{x_j \in \chi_j} p(y_R \mid x_{S_i}=x_i, x_{S_j}=x_j) e^{\xi(x_i)+\xi(x_j)}} \end{aligned} \qquad (3)$$

$$(i, j = 1,2 \text{ et } i \neq j)$$

Connaissant la distribution gaussienne du bruit, ceci permet d'écrire :

$$\Lambda(v_{S_i(l)}) = \log \left( \frac{\sum_{x_i \in \chi_i : \varphi_{i(l)}^{-1}(x_i)=1} \sum_{x_j \in \chi_j} \exp\left(-\left\|\frac{y_R - h_{S_iR} x_i - h_{S_jR} x_j}{\sigma_n}\right\|^2 + \xi(x_i) + \xi(x_j)\right)}{\sum_{x_i \in \chi_i : \varphi_{i(l)}^{-1}(x_i)=0} \sum_{x_j \in \chi_j} \exp\left(-\left\|\frac{y_R - h_{S_iR} x_i - h_{S_jR} x_j}{\sigma_n}\right\|^2 + \xi(x_i) + \xi(x_j)\right)} \right) \qquad (4)$$

Où:

$$\xi\left(x_i\right) = \sum_{l'=1}^{\log_2|\chi_i|} \varphi_{i(l')}^{-1}(x_i) Ex(v_{S_i(l')})$$

$$(5)$$

$$\xi\left(x_j\right) = \sum_{l'=1}^{\log_2|\chi_j|} \varphi_{j(l')}^{-1}(x_j) Ex(v_{S_j(l')})$$

$$(6)$$

$$(i, j = 1, 2, \ i \neq j \ \text{et} \ l' \neq l)$$

Où $\{Ex(v_{S_i(l)})\}$ sont les rapports logarithmiques des probabilités à priori sur les bits de chaque symbole, fournis par le décodeur à l'itération précédente.

Les rapports logarithmiques des probabilités (LLR) extrinsèques à la sortie du détecteur MAP sont calculés selon l'expression :

$$L(v_{S_i(l)}) = \Lambda(v_{S_i(l)}) - Ex(v_{S_i(l)})$$

$$(7)$$

Après desentrelacement effectué par un desentrelaceur $\pi_c^{-1}$ qui effectue la fonction inverse de l'entrelaceur utilisé à l'émission en association avec le codage de canal, le MUD fournit les rapports logarithmiques des probabilités (LLR) extrinsèques sur les bits codés $L(c_{S_i})$.

A chaque itération, les décodeurs DECi, schématisés à la figure 12, utilisent respectivement les vecteurs des rapports logarithmiques de probabilité (LLR) intrinsèques des bits codés $\{L(c_{S_1})\}$ et $\{L(c_{S_2})\}$ fournis par le MUD. Ils délivrent des rapports logarithmiques de probabilités extrinsèques $\{Ex(c_{S_1})\}$ et $\{Ex(c_{S_2})\}$ sur les bits codés $c_{S_1}$ et $c_{S_2}$. Après entrelacement, les rapports logarithmiques de probabilités extrinsèques $Ex(V_{S_1})$ et $Ex(V_{S_2})$ sur les bits codés et entrelacés sont exploités à l'itération suivante par le MUD comme des rapports logarithmiques de probabilités a priori. L'entrelaceur est identique à celui utilisé à l'émission en association avec le codage de canal.

A la dernière itération, chaque décodeur DECi prend une décision dure/souple et fournit un vecteur $\hat{u}_{S_i}/L(u_{S_i})$ représentatif des K bits d'information $u_{S_i}$.

Compte tenu de l'ordonnancement dans les émetteurs et le relais dans le cas semi-orthogonal half duplex, chaque émetteur émet son mot de code pendant $\alpha N$, $\alpha \in [0,1]$ premiers intervalles de transmission et le relais émet le vecteur de redondance pendant $(1-\alpha)N$ seconds intervalles de transmission.

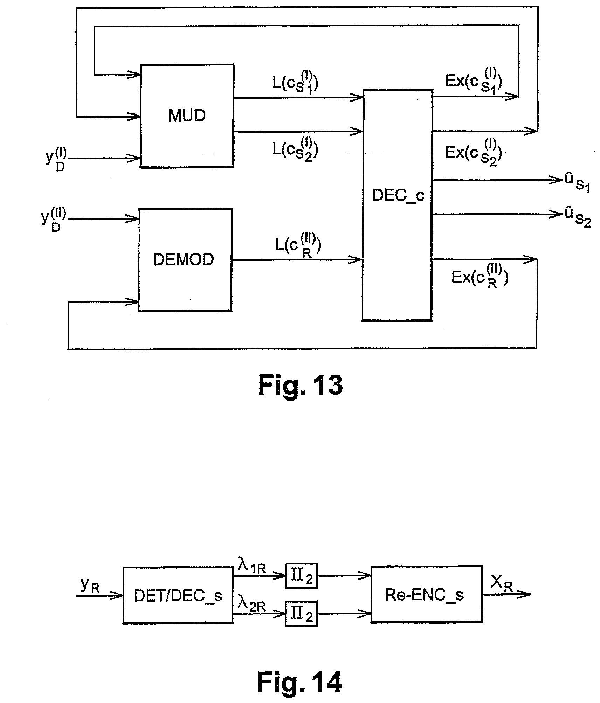

Le récepteur reçoit l'information de redondance transmise pendant les $(1-\alpha)N$ seconds intervalles de transmission émanant du relais. Il met en oeuvre un traitement pour déterminer les messages originaux en exploitant l'information de redondance ainsi que les messages superposés reçus issus des deux sources et émis pendant les $\alpha N$ premiers intervalles de transmission. Le traitement est mis en oeuvre par un détecteur/décodeur conjoint illustré par la figure 13. Par souci de simplicité, les entrelaceurs du canal ne sont pas représentés.

Le détecteur/décodeur conjoint comprend un détecteur MUD et un démodulateur DEMOD en parallèles suivis d'un décodeur conjoint DEC_c. Le MUD et le DEMOD exploitent les informations relatives respectivement aux $\alpha N$ et $(1-\alpha)N$ intervalles de transmission. Les signaux transmis pendant ces deux phases successives peuvent s'exprimer sous la forme :

$$y_{D,k}^{(I)} = h_{S_1 D,k}^{(I)} x_{S_1,k}^{(I)} + h_{S_2 D,k}^{(I)} x_{S_2,k}^{(I)} + n_k^{(I)}$$

$$(8)$$

(pour les $\alpha N$ 1$^{er}$ intervalles) avec $k=1,...,\alpha N$ et

$$y_{D,k}^{(II)} = h_{RD,k}^{(II)} x_{R,k}^{(II)} + n_k^{(II)}$$

$$(9)$$

(pour les $(1-\alpha)N$ 2$^{nd}$ intervalles) avec $k=\alpha N+1,...,N.$

La description suivante est relative à un exemple de mise en oeuvre d'un procédé de transmission et d'un procédé de réception selon l'invention, par un système MARC semi-orthogonal particulier.

Le système MARC semi-orthogonal comprend un relais half-duplex qui met en oeuvre un schéma de codage/décodage spécifique du type turbo code distribué. Les deux sources encodent les données segmentées par bloc de longueur K avec un codeur convolutif systématique récursif (RSCC) de rendement ½. Le résultat du codage consiste en des bits codés constitués de deux parties : une 1$^{er}$ partie comprend la partie systématique et une 2$^{eme}$ partie qui est une 1$^{ère}$ partie de redondance. Les émetteurs émettent (après entrelacement et modulation) la 1$^{ere}$ et la 2$^{eme}$ partie des bits codés à destination du relais et du destinataire (récepteur) pendant les 1$^{er}$ intervalles de transmission.

Le relais reçoit les signaux émis pendant les 1$^{er}$ intervalles de transmission et fait une détection/décodage conjointe souple suivi d'un encodage souple et d'une compression comme décrit précédemment en regard de la figure 8.

Suite au décodage souple, le relais obtient $\lambda_{1R}$ = **L**($\mathbf{u}_{S_1}$) et $\lambda_{2R}$ = **L**($\mathbf{u}_{S_2}$) représentatifs des K bits d'information de chaque source $u_{S_i}$.

Le relais détermine ensuite à partir des $\lambda_{1R}$ et $\lambda_{2R}$, le vecteur de redondance $x_R$ à émettre pendant les seconds intervalles de transmission. A cette fin, le relais entrelace les $\lambda_{1R}$ et $\lambda_{2R}$ représentatifs des flux des deux sources, au moyen de deux entrelaceurs $\pi_2$, puis encode ces données entrelacées au moyen d'un codeur souple RSCC Re_ENC_s de rendement 2/3. Le relais émet uniquement les bits de parité (sélection de colonnes correspondant à la parité). Dans ce cas : $N = 3K$, $\alpha$ = 2/3. Cette détermination est illustrée par la figure 14.

A la destination, le procédé de réception applique un modèle gaussien pour modéliser la perturbation totale sur le signal reçu provenant du relais.

Pour maximiser le SNR (Signal Noise Ratio ou rapport signal à bruit) à la destination, le système MARC utilise un critère MMSUE (Minimum Mean Squared Uncorrelated Error) : le relais fait une estimation optimale à partir des probabilités à posteriori. Ce choix de critère permet d'optimiser le rôle du relais. Le principe de la compression MMSUE effectuée par le relais est le suivant.

Le relais génère des probabilités sur les symboles $s_{R,k}$ appartenant à la constellation $\chi_R$: $\varphi_R : F_2^m \rightarrow \chi_R \subseteq C$, où chaque symbole modulé appartient à l'ensemble complexe $\chi_R$ de cardinalité $|\chi_R|=2^m$. Donc, $v_{R,k(l)} = \varphi_{R(l)}^{-1}(s_{R,k})$ $k=1,...,N_R$, $l=1,...,m$ désigne le $l^{ème}$ bit de l'étiquetage binaire de $s_{R,k}$. L'énergie des symboles est normalisée à un pour simplifier les notations.

Le relais émet des informations sur les paquets des noeuds $S_1$ et $S_2$ encodées et modulées avec $C_R$ sur $N_R$ intervalles de transmission. Les symboles complexes suivants sont émis par le relais pendant les $N_R$ intervalles de transmission :

$$x_{R,k} = f(s_{R,k}) = \sqrt{\frac{P_R}{\sigma_{\tilde{s}_{R,k}}^2}}\tilde{s}_{R,k}, \qquad k = 1,...,N_R \qquad (10)$$

avec

$$\tilde{s}_{R,k} = \sum_{a \in \chi_R} s_{R,k} P(s_{R,k} = a) \qquad (11)$$

et

$$\sigma_{\tilde{s}_R}^2 = \frac{1}{N_R}\sum_{k=1}^{N_R}\left|\tilde{s}_{R,k}\right|^2 \qquad (12)$$

Où $P_R$ est l'énergie disponible au relais.

Au récepteur, dans le cas particulier d'un canal gaussien sans interférence, les symboles $x_{R,k}$ sont détectés au sens de l'erreur quadratique moyenne pour obtenir les estimées $\hat{x}_{R,k} = x_{R,k} + n_k$ où $n_k$ est supposé Gaussien de variance connue $\sigma^2$, selon une première approximation gaussienne.

En généralisant le concept de MMSUE (minimum mean squared uncorrelated error) à des données codées, les estimées $\hat{x}_{R,k}$ peuvent s'exprimer sous la forme :

$$\hat{x}_{R,k} = x_{R,k} + n_k$$

$$= \frac{\sigma_{\tilde{s}_R}}{\sigma_{\tilde{s}_R}^2} \sqrt{P_R}(s_{R,k} + e_k) + n_k$$

$$= \sigma_{\tilde{s}_R} \sqrt{P_R} s_{R,k} + \sigma_{\tilde{s}_R} \sqrt{P_R} e_k + n_k$$

$$= \sigma_{\tilde{s}_R} \sqrt{P_R} s_{R,k} + n_k' \tag{13}$$

la variance de $n'_k$ étant $\sigma^2 + P_R(1 - \sigma_{\tilde{s}_R}^2)$

Une deuxième approximation gaussienne sur $n'_k$, permet de retrouver les probabilités $P(s_{R,j} = a)$, $a \in \chi_R$ qui sont proportionnelles à :

$$e^{-\frac{\left|\hat{x}_{R,k} - \sigma_{\tilde{s}_R} \sqrt{P_R} s_{R,k}\right|^2}{\sigma^2 + P_R(1 - \sigma_{\tilde{s}_R}^2)}} \tag{14}$$

Par hypothèse, les noeuds du réseau distribué connaissent leur puissance d'émission respective.

Le relais émet le vecteur de redondance $x_R$ pendant les seconds intervalles de transmission correspondant uniquement aux K bits de parité du code récursif systématique.

Ainsi, le destinataire reçoit pendant les 1er intervalles de transmission une superposition des mots de code émis par les deux émetteurs : les mots de code comprenant la partie systématique et une 1ère partie de redondance des bits codés. Pendant les seconds intervalles de transmission, le destinataire reçoit le vecteur de redondance déterminé par le relais.

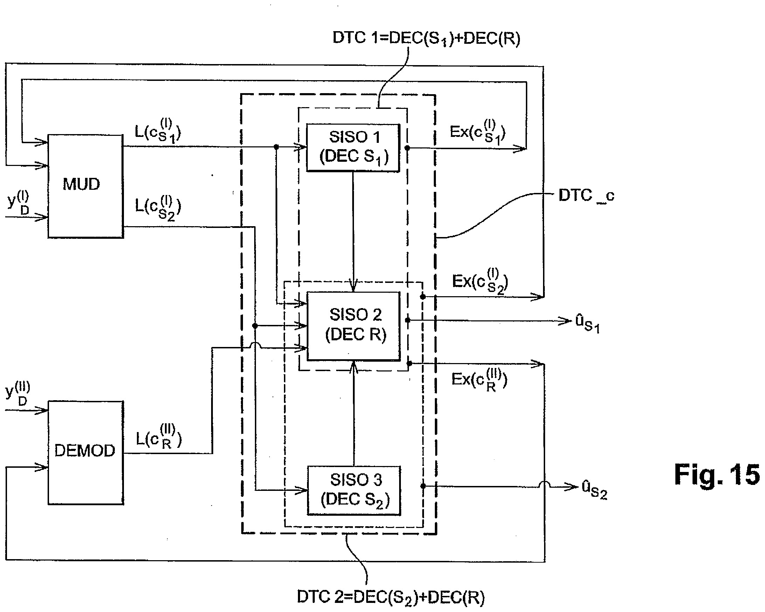

Après réception de' ces différents mots de code, le récepteur détecte et décode les différents flux reçus au moyen d'un détecteur/décodeur conjoint. Ce détecteur/décodeur conjoint, illustré par la figure 15, comprend un détecteur MUD et un démodulateur DEMOD en parallèles suivis d'un décodeur conjoint DEC_c.

A chaque itération, le MUD utilise un détecteur MAP pour séparer les deux flux (des deux sources) et calculer les rapports logarithmiques de probabilités (LLR) sur les bits codés et en parallèle, le démodulateur DEMOD calcule,à partir des symboles reçus émanant du relais, les LLR sur les bits codés suivant le critère MAP.

Le MUD exploite les signaux correspondant aux premiers intervalles de transmission et sépare les flux des deux sources ; il fournit les rapports logarithmiques de probabilités (LLR) $\mathbf{L}(\mathbf{c}_{S_1}^{(I)})$ et $\mathbf{L}(\mathbf{c}_{S_2}^{(I)})$ sur les bits codés émis pendant les 1er intervalles de transmission. Le principe de fonctionnement du MUD est identique au fonctionnement déjà décrit en regard de la figure 11.

Le démodulateur DEMOD exploite les signaux correspondant aux seconds intervalles de transmission pour détecter et démoduler le flux provenant du relais. Le démodulateur DEMOD utilise le critère MAP pour la démodulation tout en prenant en compte la compression MMSUE effectuée dans le relais : le démodulateur DEMOD doit prendre en compte la variance du bruit équivalent MMSUE lors de la démodulation.

Le démodulateur DEMOD fournit les rapports logarithmiques de probabilités (LLR) $\mathbf{L}(\mathbf{c}_R^{(II)})$ sur les bits codés du relais émis pendant les 2nd intervalles de transmission. Le signal reçu en entrée du démodulateur DEMOD peut s'exprimer sous la forme :

$$y_D^{(II)} = h_{RD}^{(II)} x_{R,k}^{(II)} + n_k^{(II)}$$

$$= h_{RD}^{(II)} \left( \sigma_{\tilde{s}_R^{(II)}} \sqrt{P_R} (s_{R,k}^{(II)} + e_k^{(II)}) \right) + n_k^{(II)} \qquad k = 2K+1,...,3K \tag{15}$$

$$= h_{RD}^{(II)} \sigma_{\tilde{s}_R^{(II)}} \sqrt{P_R} s_{R,k}^{(II)} + n_k'$$

où :

$$n_k' = h_{RD}^{(II)} \sigma_{\bar{s}_R^{(II)}} \sqrt{P_R} e_k^{(II)} + n_k^{(II)} \qquad (16)$$

est le bruit équivalent à la destination, de moyenne nulle et de variance $\sigma_{n'}^2$ :

$$\sigma_{n'}^2 = \sigma_{n^{(II)}}^2 + P_R \left| h_{RD}^{(II)} \right|^2 (1 - \sigma_{\bar{s}_R^{(II)}}^2) \qquad (17)$$

En considérant le flux reçu et connaissant l'expression du bruit, le démodulateur DEMOD détermine : (Pour simplifier les notations, les indices de temps sont omis.)

$$\Lambda(v_{R(l)}^{(II)}) = \log\left( \sum_{s_R \in \chi_R : \varphi_{R(l)}^{-1}(s_R)=1} A \Big/ \sum_{s_R \in \chi_R : \varphi_{R(l)}^{-1}(s_R)=0} B \right) \qquad (18)$$

avec :

$$A = \exp\left( -\left\| \frac{y_D^{(II)} - h_{RD}^{(II)} \sigma_{\bar{s}_R^{(II)}} \sqrt{p_R} s_R}{\sigma_{n'}} \right\|^2 + \xi(s_R) \right) \qquad (19)$$

$$B = \exp\left( -\left\| \frac{y_D^{(II)} h_{RD}^{(II)} \sigma_{\bar{s}_R} \sqrt{p_R} s_R}{\sigma_{n'}} \right\|^2 + \xi(s_R) \right) \qquad (20)$$

Où:

$$\xi(s_R) = \sum_{l'=1}^{\log_2|\chi_R|} \varphi_{R(l')}^{-1}(s_j) Ex(v_{R(l')}^{(II)}) \qquad (21)$$

et :

$$L(v_{R(l)}^{(II)}) = \Lambda(v_{R(l)}^{(II)}) - Ex(v_{R(l)}^{(II)}) \qquad (22)$$

Après desentrelacement, les rapports logarithmiques de probabilités intrinsèques des bits de redondance $L(c_R^{(II)})$ sont obtenues en sortie du démodulateur DEMOD.

Le décodeur conjoint DEC_c est formé de deux turbo décodeurs DTC1, DTC2 comportant chacun deux décodeurs respectivement SISO1, SISO2 et SISO3, SISO2 à entrées souples et sorties souples dont un partagé : SISO2(DEC R). Les décodeurs SISOi exploitent les rapports logarithmiques de probabilités intrinsèques des bits codés $L(c_{S_1}^{(I)})$, $L(c_{S_2}^{(I)})$ et des bits de redondance $L(c_R^{(II)})$ et fournissent des rapports logarithmiques de probabilités extrinsèques $Ex(c_{S_1}^{(I)})$, $Ex(c_{S_2}^{(I)})$, et $Ex(c_R^{(II)})$ sur les bits codés. Après entrelacement, ces valeurs sont exploitées comme des informations a priori par le MUD et le démodulateur DEMOD.

Soient $L_{S_i}^{I}$ l'information souple des bits systématiques des deux sources et $L_{P_i}^{I}$, $L_{P_R}^{II}$ les informations souples des bits de parité correspondant aux deux sources et au relais fournis par le MUD et le démodulateur DEMOD ($i$=1,2).

Soient $\mathbb{E}x_{S_i(j)}^I$, $\mathbb{E}x_{P_i(j)}^I$, et $\mathbb{E}x_{P_R(j)}^{II}$ les informations extrinsèques générées par les décodeurs SISO $j$ ($j$=1,...,3).

Le déroulement du traitement itératif mis en oeuvre par le décodeur DEC_c est le suivant :

1. Le MUD exploite (après ré-entrelacement) $\mathbb{E}x_{S_1(1)}^I + \Pi_2^{-1}(\mathbb{E}x_{S_1(2)}^I)$, $\mathbb{E}x_{P_1(1)}^I$, $\Pi_2^{-1}(\mathbb{E}x_{S_2(2)}^I) + \mathbb{E}x_{S_2(3)}^I$, $\mathbb{E}x_{P_2(3)}^I$, et le démodulateur DEMOD exploite (après ré-entrelacement) $\mathbb{E}x_{P_R(2)}^{II}$, comme des informations à priori et ils produisent les rapports logarithmiques de probabilités intrinsèques (la première itération est différente dans le sens où il n'y a aucune information à priori).

2. Les DTC 1 et DTC 2 sont actifs :

2.a) SISO1 et SISO3 fonctionnent simultanément :

- SISO1 exploite $\mathbf{L}_{S_1}^I$ et $\mathbf{L}_{P_1}^I$ et exploite $\Pi_2^{-1}(\mathbb{E}x_{S_1(2)}^I)$ obtenues à l'itération précédente comme des informations à priori et calcule au moyen d'un algorithme BCJR $\mathbb{E}x_{S_1(1)}^I$ et $\mathbb{E}x_{P_1(1)}^I$,

- SISO3 exploite $\mathbf{L}_{S_2}^I$ et $\mathbf{L}_{P_2}^I$ let exploite $\Pi_2^{-1}(\mathbb{E}x_{S_2(2)}^I)$ obtenues à l'itération précédente comme des informations à priori et calcule au moyen d'un algorithme BCJR $\mathbb{E}x_{S_2(3)}^I$ et $\mathbb{E}x_{P_2(3)}^I$,

2.b) SISO2 exploite $\Pi_2(\mathbf{L}_{S_1}^I)$, $\Pi_2(\mathbf{L}_{S_2}^I)$, et $\mathbf{L}_{P_R}^{II}$, et exploite $\Pi_2(\mathbb{E}x_{S_1(1)}^I)$ et $\Pi_2(\mathbb{E}x_{S_2(3)}^I)$ comme des informations à priori, et calcule au moyen d'un algorithme BCJR $\mathbb{E}x_{S_2(2)}^I$, $\mathbb{E}x_{P_R(2)}^{II}$, et $\mathbb{E}x_{S_1(2)}^I$

3. Revenir à l'étape 1 avec prise en compte des nouvelle valeurs à priori.

Après quelques itérations, les décisions dures se font sur la base de :

$$\mathbf{L}_{S_1}^I + \mathbb{E}x_{S_1(1)}^I + \Pi_2^{-1}(\mathbb{E}x_{S_1(2)}^I)$$

et

$$\mathbf{L}_{S_2}^I + \Pi_2^{-1}(\mathbb{E}x_{S_2(2)}^I) + \mathbb{E}x_{S_2(3)}^I$$

pour fournir respectivement $\hat{\mathbf{u}}_{S_1}$ et $\hat{\mathbf{u}}_{S_2}$.

Selon une utilisation particulière, les deux sources correspondent à deux utilisateurs différents, par exemple deux terminaux mobiles. Selon une autre utilisation, les deux sources peuvent correspondre à deux services différents accessibles depuis un même terminal mais dans ce cas, le terminal est équipé d'au moins deux antennes qui déterminent deux canaux de propagation différents entre le terminal et le relais et entre le terminal et la destination.

Références :

[1] C. Hausl, F. Schrenckenbach, I. Oikonomidis, G. Bauch, "Iterative network and channel coding on a Tanner graph," Proc. Annual Allerton Conference on Communication, Control and Computing, Monticello, IL, 2005.
[2] C. Hausl, P. Dupraz, "Joint Network-Channel Coding for the Multiple-Access Relay Channel," Proc. IEEE SECON'06, Reston, VA, Sept. 2006.
[3] S. Yang, R. Koetter, "Network coding over a noisy relay: A belief propagation approach", in Proc. IEEE ISIT'07, Nice, France, June 2007.
[4] L.Bahl, J.Cocke, F.Jelinek, and J.Raviv, "Optimal Decoding of Linear Codes for minimizing symbol error rate", IEEE Transactions on Information Theory, vol. IT-20(2), pp.284-287, March 1974.

**Revendications**

1. Procédé (1) de transmission d'un signal numérique destiné à un réseau à au moins quatre noeuds comprenant deux émetteurs (S$_1$, S$_2$), un relais (R) half-duplex et un récepteur (D) séparés entre eux par des liens non orthogonaux sauf entre le relais et la destination entre lesquels le lien est orthogonal, mettant en oeuvre un code de réseau spatialement distribué, comprenant :

   - une étape de codage (2), dans chaque émetteur, délivrant un mot de code par bloc de K bits d'information,
   - une étape d'émission (3), dans les émetteurs, du mot de code pendant $\alpha N$ intervalles de transmission, $\alpha \in [0,1]$
   - une étape de détection/décodage conjoint itératif (4), dans le relais, pour séparer les flux interférants provenant des émetteurs et déterminer par flux un vecteur représentatif des K bits d'information associés au mot de code,
   - une étape de codage conjoint (5), dans le relais, des deux vecteurs pour déterminer une information de redondance,
   - un ordonnancement dans le relais pour émettre (6) l'information de redondance pendant les (1-$\alpha$)$N$ suivants intervalles de transmission.

2. Procédé selon la revendication 1, dans lequel l'étape de détection/décodage conjoint itératif met en oeuvre un décodage dur.

3. Procédé selon la revendication 1, dans lequel l'étape de détection/décodage conjoint itératif met en oeuvre un décodage souple et l'étape de codage conjoint met en oeuvre un codage souple et une marginalisation effectuée au niveau bit.

4. Procédé selon la revendication 1, dans lequel l'étape de détection/décodage conjoint itératif met en oeuvre un décodage souple et l'étape de codage conjoint met en oeuvre un codage souple et une compression.

5. Procédé selon la revendication précédente, dans lequel la compression est effectuée en utilisant un critère d'erreur quadratique moyenne non corrélée (MMSUE).

6. Procédé selon la revendication 1, mettant en oeuvre un turbo code distribué entre les émetteurs et le relais et dans lequel l'étape de codage dans les émetteurs met en oeuvre un codeur convolutif.

7. Programme d'ordinateur sur un support d'informations, ledit programme comportant des instructions de programme adaptées à la mise en oeuvre d'un procédé de transmission d'un signal numérique selon l'une quelconque des revendications 1 à 6, lorsque ledit programme est chargé et exécuté dans un système MARC semi-orthogonal destiné à mettre en oeuvre le procédé de transmission.

8. Support d'informations comportant des instructions de programme adaptées à la mise en oeuvre d'un procédé de transmission d'un signal numérique selon l'une quelconque des revendications 1 à 6, lorsque ledit programme est chargé et exécuté dans un système MARC semi-orthogonal destiné à mettre en oeuvre le procédé de transmission.

9. Relais (R) half-duplex destiné à un système MARC semi-orthogonal pour la mise en oeuvre d'un procédé de transmission selon l'une quelconque des revendications 1 à 6, le dit relais comprenant :

   - un moyen (DET/DEC) de détection/décodage conjoint itératif pour séparer les flux interférants provenant de deux émetteurs du système MARC semi-orthogonal et déterminer, par flux, un vecteur représentatif de K bits d'information associés à un mot de code émis par un émetteur pendant $\alpha N$ intervalles de transmission, $\alpha \in [0,1]$,
   - un moyen (Re_ENC) de codage conjoint des vecteurs des deux flux pour déterminer une information de redondance,
   - un moyen pour émettre l'information de redondance pendant (1-$\alpha$)$N$ intervalles de transmission qui suivent les $\alpha N$ intervalles de transmission pendant lesquels les mots de code sont émis par les deux émetteurs.

10. Système (SYS) MARC semi-orthogonal dans lequel le relais est selon la revendication 9.

11. Procédé de réception destiné à un récepteur d'un système MARC semi-orthogonal destiné à mettre en oeuvre un procédé de transmission selon l'une des revendications 1 à 6, comprenant :

- une étape de mémorisation dans un bloc de données reçues pendant $\alpha N$, intervalles de transmissions, $\alpha \in [0,1]$, correspondant à K bits d'information codés par émetteur sous la forme d'un mot de code émis pendant les $\alpha N$ intervalles de transmission,

et comprenant de manière itérative :

- une étape de détection d'information de redondance provenant d'un relais half-duplex reçue pendant $(1-\alpha)N$ intervalles de transmission qui suivent les $\alpha N$ intervalles de transmission,
- une étape de détection pour séparer les flux interférants provenant des émetteurs à partir d'un bloc de données reçues,
- une étape de décodage conjoint pour déterminer par émetteur une valeur de décodage des K bits d'information en décodant conjointement les flux séparés et l'information de redondance détectée.

12. Récepteur (D) destiné à un système MARC semi-orthogonal destiné à mettre en oeuvre un procédé de transmission selon l'une des revendications 1 à 6, le dit récepteur comprenant :

- un moyen pour mémoriser dans un bloc des données reçues pendant $\alpha N$, intervalles de transmissions correspondant à K bits d'information codés par émetteur sous la forme d'un mot de code émis pendant les $\alpha N$ intervalles de transmissions, $\alpha \in [0,1]$,
- deux moyens (MUD, DEMOD) de détection bloc en parallèles suivis d'un décodeur conjoint (DEC_c) pour, de manière itérative, séparer les deux flux interférants provenant des émetteurs pendant les $\alpha N$ intervalles de transmission, détecter le flux provenant du relais half-duplex pendant les $(1-\alpha)N$ intervalles de transmission suivants et déterminer à partir des flux séparés et du flux détecté, une valeur de décodage des K bits d'information par émetteur.

## Patentansprüche

1. Verfahren (1) zur Übertragung eines digitalen Signals, das für ein Netz mit mindestens vier Knoten bestimmt ist, umfassend zwei Sender ($S_1$, $S_2$), ein Halbduplex-Relais (R) und einen Empfänger (D), die durch nichtorthogonale Verbindungen voneinander getrennt sind, außer zwischen dem Relais und dem Ziel, zwischen welchen die Verbindung orthogonal ist, wobei ein räumlich verteilter Netzcode umgesetzt wird, umfassend:

- einen Schritt des Codierens (2) in jedem Sender, wobei ein Codewort durch einen Block von K Informationsbits geliefert wird,
- einen Schritt des Sendens (3), in den Sendern, des Codeworts während $\alpha$N Übertragungsintervallen, $\alpha \in [0,1]$
- einen Schritt des Erkennens/iterativen gemeinsamen Decodierens (4) in dem Relais, um die interferierenden Flüsse, die von den Sendern kommen, zu trennen und durch einen Fluss einen Vektor zu bestimmen, der für die K Informationsbits repräsentativ ist, die mit dem Codewort in Verbindung stehen,
- einen Schritt des gemeinsamen Codierens (5) der zwei Vektoren in dem Relais, um eine Redundanzinformation zu bestimmen,
- eine Planung in dem Relais, um die Redundanzinformation während der $(1-\alpha)$N folgenden Übertragungsintervallen zu senden (6).

2. Verfahren nach Anspruch 1, wobei der Schritt des Erkennens/iterativen gemeinsamen Decodierens eine harte Decodierung umsetzt.

3. Verfahren nach Anspruch 1, wobei der Schritt des Erkennens/iterativen gemeinsamen Decodierens eine weiche Decodierung umsetzt und der Schritt des gemeinsamen Codierens eine weiche Codierung und eine Marginalisierung, die auf der Bit-Ebene ausgeführt wird, umsetzt.

4. Verfahren nach Anspruch 1, wobei der Schritt des Erkennens/iterativen gemeinsamen Decodierens eine weiche Decodierung umsetzt und der Schritt des gemeinsamen Codierens eine weiche Codierung und eine Komprimierung umsetzt.

5. Verfahren nach dem vorhergehenden Anspruch, wobei die Komprimierung mithilfe eines Kriteriums eines nicht korrelierten mittleren quadratischen Fehlers (MMSUE) ausgeführt wird.

6. Verfahren nach Anspruch 1, das einen Turbocode umsetzt, der zwischen den Sendern und dem Relais verteilt wird und wobei der Schritt des Codierens in den Sendern einen konvolutiven Codierer umsetzt.

7. Computerprogramm auf einem Informationsträger, das Programm umfassend Programmanweisungen, die zur Umsetzung eines Verfahrens zur Übertragung eines digitalen Signals nach einem der Ansprüche 1 bis 6 angepasst sind, wenn das Programm in ein semi-orthogonales MARC-System, das dazu bestimmt ist, das Verfahren zur Übertragung umzusetzen, geladen ist und darin ausgeführt wird.

8. Informationsträger, umfassend Programmanweisungen, die zur Umsetzung eines Verfahrens zur Übertragung eines digitalen Signals nach einem der Ansprüche 1 bis 6 angepasst sind, wenn das Programm in ein semi-orthogonales MARC-System, das dazu bestimmt ist, das Verfahren zur Übertragung umzusetzen, geladen ist und darin ausgeführt wird.

9. Halbduplex-Relais (R), das für ein semi-orthogonales MARC-System zur Umsetzung eines Verfahrens zur Übertragung nach einem der Ansprüche 1 bis 6 bestimmt ist, das Relais umfassend:

- ein Mittel (DET/DEC) zum Erkennen/iterativen gemeinsamen Decodieren, um die interferierenden Flüsse, die von den zwei Sendern des semi-orthogonalen MARC-Systems kommen, zu trennen und durch einen Fluss einen Vektor zu bestimmen, der für K Informationsbits repräsentativ ist, die mit einem Codewort in Verbindung stehen, das von einem Sender während $\alpha N$ Übertragungsintervallen gesendet wird, $\alpha \in [0,1]$,
- ein Mittel (Re_ENC) zum gemeinsamen Codieren der Vektoren der zwei Flüsse, um eine Redundanzinformation zu bestimmen,
- ein Mittel zum Senden der Redundanzinformation während $(1-\alpha)N$ Sendeintervallen, die auf die $\alpha N$ Übertragungsintervalle folgen, während welchen die Codewörter von den zwei Sendern gesendet werden.

10. Semi-orthogonales MARC-System (SYS), wobei das Relais dem Anspruch 9 entspricht.

11. Empfangsverfahren, das für einen Empfänger eines semi-orthogonalen MARC-Systems bestimmt ist, das dazu bestimmt ist, ein Verfahren zur Übertragung nach einem der Ansprüche 1 bis 6 umzusetzen, umfassend:

- einen Schritt des Speicherns in einem Block von Daten, die während $\alpha N$ Übertragungsintervallen empfangen werden, $\alpha \in [0,1]$, die K Informationsbits entsprechen, die von einem Sender in Form eines Codeworts codiert werden, das während der $\alpha N$ Übertragungsintervalle gesendet wird,

und umfassend auf iterative Weise:

- einen Schritt des Erkennens einer Redundanzinformation, die von einem Halbduplex-Relais kommt, die während $(1-\alpha)N$ Übertragungsintervallen empfangen wird, die auf die $\alpha N$ Übertragungsintervalle folgen,
- einen Schritt des Erkennens, um die interferierenden Flüsse, die von den Sendern kommen, anhand eines Blocks empfangener Daten zu trennen,
- einen Schritt des gemeinsamen Decodierens, um durch einen Sender einen Decodierungswert der K Informationsbits durch gemeinsames Decodieren der getrennten Flüsse und der erkannten Redundanzinformation zu bestimmen.

12. Empfänger (D), der für ein semi-orthogonales MARC-System bestimmt ist, das dazu bestimmt ist, ein Verfahren zur Übertragung nach einem der Ansprüche 1 bis 6 umzusetzen, der Empfänger umfassend:

- ein Mittel zum Speichern in einem Block der Daten, die während aN Übertragungsintervallen empfangen werden, die K Informationsbits entsprechen, die von einem Sender in Form eines Codeworts codiert werden, das während der $\alpha N$ Übertragungsintervalle gesendet wird, $\alpha \in [0,1]$,
- zwei parallele Blockerkennungsmittel (MUD, DEMOD), auf die ein gemeinsamer Decoder (DEC_c) folgt, um auf iterative Weise die zwei interferierenden Flüsse zu trennen, die während der $\alpha N$ Übertragungsintervalle von den Sendern kommen, den Fluss zu erkennen, der während der $(1-\alpha)N$ folgenden Übertragungsintervalle von dem Halbduplex-Relais kommt, und anhand der getrennten Flüsse und des erkannten Flusses einen Decodierungswert der K Informationsbits durch einen Sender zu bestimmen.

**Claims**

1. Method (1) for transmitting a digital signal intended for a network with at least four nodes comprising two transmitters ($S_1$, $S_2$), a half-duplex relay (R) and a receiver (D) separated from one another by non-orthogonal links except between the relay and the destination, between which the link is orthogonal, implementing a spatially distributed network code, comprising:

   - a step of coding (2), in each transmitter, delivering a code word per block of K information bits,
   - a step of transmitting (3), in the transmitters, the code word during $\alpha N$ transmission intervals, $\alpha \in [0,1]$,
   - a step of iterative joint detection/decoding (4), in the relay, so as to separate the interfering streams originating from the transmitters and determine per stream a vector representative of the K information bits associated with the code word,
   - a step of joint coding (5), in the relay, of the two vectors so as to determine redundancy information,
   - a scheduling in the relay so as to send (6) the redundancy information during the $(1-\alpha)N$ following transmission intervals.

2. Method according to Claim 1, in which the iterative joint detection/decoding step implements a hard decoding.

3. Method according to Claim 1, in which the iterative joint detection/decoding step implements a soft decoding and the joint coding step implements a soft coding and a marginalization performed at the bit level.

4. Method according to Claim 1, in which the iterative joint detection/decoding step implements a soft decoding and the joint coding step implements a soft coding and a compression.

5. Method according to the preceding claim, in which the compression is performed by using a mean squared uncorrelated error criterion (MMSUE).

6. Method according to Claim 1, implementing a turbo code distributed between the transmitters and the relay and in which the coding step in the transmitters implements a convolutional coder.

7. Computer program on an information medium, said program comprising program instructions suitable for the implementation of a method for transmitting a digital signal according to any one of Claims 1 to 6, when said program is loaded and executed in a semi-orthogonal MARC system intended to implement the method of transmission.

8. Information medium comprising program instructions adapted to the implementation of a method for transmitting a digital signal according to any one of Claims 1 to 6, when said program is loaded and executed in a semi-orthogonal MARC system intended to implement the method of transmission.

9. Half-duplex relay (R) intended for a semi-orthogonal MARC system for the implementation of a method of transmission according to any one of Claims 1 to 6, said relay comprising:

   - a means (DET/DEC) of iterative joint detection/decoding for separating the interfering streams originating from two transmitters of the semi-orthogonal MARC system and for determining, per stream, a vector representative of K information bits associated with a code word transmittted by a transmitter during $\alpha N$ transmission intervals, $\alpha \in [0,1]$,
   - a means (Re_ENC) of joint coding of the vectors of the two streams for determining redundancy information,
   - a means for transmitting the redundancy information during $(1-\alpha)N$ transmission intervals which follow the $\alpha N$ transmission intervals during which the code words are transmitted by the two transmitters.

10. Semi-orthogonal MARC system (SYS) in which the relay is according to Claim 9.

11. Method of reception intended for a receiver of a semi-orthogonal MARC system intended to implement a method of transmission according to one of Claims 1 to 6, comprising:

   - a step of storage in a block of data received during $\alpha N$, transmission intervals, $\alpha \in [0,1]$, corresponding to K information bits coded per transmitter in the form of a code word transmitted during the $\alpha N$ transmission intervals,

   and comprising in an iterative manner:

- a step of detection of redundancy information originating from a half-duplex relay and received during $(1-\alpha)N$ transmission intervals which follow the $\alpha N$ transmission intervals,
- a detection step for separating the interfering streams originating from the transmitters on the basis of a block of data received,
- a joint decoding step for determining per transmitter a decoding value for the K information bits by jointly decoding the separate streams and the detected redundancy information.

12. Receiver (D) intended for a semi-orthogonal MARC system intended to implement a method of transmission according to one of Claims 1 to 6, said receiver comprising:

- a means for storing in a block data received during $\alpha N$, transmission intervals corresponding to K information bits coded per transmitter in the form of a code word transmitted during the $\alpha N$ transmission intervals, $\alpha \in [0,1]$,
- two means (MUD, DEMOD) of block detection in parallel, followed by a joint decoder (DEC_c) for, in an iterative manner, separating the two interfering streams originating from the transmitters during the $\alpha N$ transmission intervals, detecting the stream originating from the half-duplex relay during the $(1-\alpha)N$ following transmission intervals and determining on the basis of the separate streams and of the detected stream, a decoding value for the K information bits per transmitter.

Fig. 1

Fig. 2

Fig. 3

**Fig. 4**

**Fig. 5**

Fig. 6

Fig. 7

Fig. 8

Fig. 9

**Fig. 10**

**Fig. 11**

**Fig. 12**

**Fig. 13**

**Fig. 14**

Fig. 15

DTC 1=DEC($S_1$)+DEC(R)

SISO 1
(DEC $S_1$)

SISO 2
(DEC R)

SISO 3
(DEC $S_2$)

MUD

DEMOD

$y_D^{(I)}$

$y_D^{(II)}$

$L(c_{S_1}^{(I)})$

$L(c_{S_2}^{(I)})$

$L(c_R^{(II)})$

$Ex(c_{S_1}^{(I)})$

$Ex(c_{S_2}^{(I)})$

$Ex(c_R^{(II)})$

$\hat{u}_{S_1}$

$\hat{u}_{S_2}$

DTC _c

DTC 2=DEC($S_2$)+DEC(R)

**EP 2 507 930 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2009287979 A1, WANG HAIFENG [CN]

**Littérature non-brevet citée dans la description**

- Iterative network and channel coding on a Tanner graph. **C. HAUSL ; F. SCHRENCKENBACH ; I. OIKONOMIDIS ; G. BAUCH.** Proc. Annual Allerton Conference on Communication. Control and Computing, 2005
- **C. HAUSL ; P. DUPRAZ.** Joint Network-Channel Coding for the Multiple-Access Relay Channel. *Proc. IEEE SECON'06,* Septembre 2006
- **S. YANG ; R. KOETTER.** Network coding over a noisy relay: A belief propagation approach. *Proc. IEEE ISIT'07,* Juin 2007
- **L.BAHL ; J.COCKE ; F.JELINEK ; J.RAVIV.** Optimal Decoding of Linear Codes for minimizing symbol error rate. *IEEE Transactions on Information Theory,* Mars 1974, vol. IT-20 (2), 284-287